# EUROPEAN PATENT SPECIFICATION

(11) **EP 4 112 220 B1**
(45) Date of publication and mention of the grant of the patent: **06.08.2025**
(21) Application number: 21761258.9
(22) Date of filing: 10.02.2021
(51) Int. Cl.: B23K 26/0622, H01S 3/00, H01S 5/062

(54) **LASER PROCESSING DEVICE AND LASER PROCESSING METHOD**
LASERBEARBEITUNGSVORRICHTUNG UND LASERBEARBEITUNGSVERFAHREN
DISPOSITIF ET PROCÉDÉ DE TRAITEMENT AU LASER

(30) Priority: 26.02.2020 JP 2020030762
(43) Date of publication of application: 04.01.2023
(73) Proprietor: Hamamatsu Photonics K.K., Hamamatsu-shi, Shizuoka 435-8558 (JP)
(72) Inventor: KURITA, Takashi, Hamamatsu-shi, Shizuoka 435-8558 (JP); KAWAI, Kazuki, Hamamatsu-shi, Shizuoka 435-8558 (JP)
(74) Representative: Grünecker Patent- und Rechtsanwälte PartG mbB
(86) International application number: PCT/JP2021/005012
(87) International publication number: WO 2021/172020

(56) References cited:
- WO-A1-2018/105082
- WO-A1-2018/110222
- WO-A1-2020/059247
- JP-A- 2010 082 672
- JP-A- 2015 503 856
- JP-A- 2017 064 747
- US-A1- 2015 336 208
- US-B2- 8 816 246

## Description

### Technical Field

The present disclosure relates to a laser processing apparatus and a laser processing method.

### Background Art

Patent Document 1 discloses a technique related to a laser processing method. In the method, a material removal rate is increased by combining at least two light pulses (bursts) each having a pulse width of 10 picoseconds to 100 picoseconds. For generating the two light pulses with a time difference, an optical path of laser light from a laser oscillator is branched by a beam splitter, the light is propagated through two optical paths having different optical path lengths, and then the optical paths are combined by a beam combiner. US 8 816 246 B2 relates to a method and apparatus for drilling using a series of laser pulses.

Patent Document 2 discloses a technique related to a laser processing method and a laser processing apparatus. In the method and the apparatus, two types of light pulses having different pulse widths are applied to a processing object. For this purpose, in one example, a laser light source for outputting one light pulse and another laser light source for outputting the other light pulse are provided.

### Citation List

### Patent Literature

Patent Document 1: Japanese Patent Application Laid-Open Publication No. 2005-511314. Patent Document 2: Japanese Patent Application Laid-Open Publication No. 2013-128088

### Summary of Invention

### Technical Problem

In recent years, a technique for performing laser processing using a light pulse having a time width on the order of nanoseconds or picoseconds has been studied. In such laser processing, various effects in the laser processing can be obtained by performing irradiation with a plurality of light pulses with a time difference.

For example, in Patent Document 1 described above, it is described that the material removal rate is increased by performing irradiation with the two light pulses with a time difference. In addition, by making the time waveform of the light pulse different between the plurality of light pulses, additional effects may be achieved. For example, in Patent Document 2 described above, it is described that damage to a non-processing region can be avoided by performing irradiation with the two light pulses having different time widths.

However, in the method described in Patent Document 1, since the time difference between the two light pulses is realized by an optical path difference between the two optical paths, an optical path difference corresponding to a desired time interval is required. For example, when the time difference is 5 nanoseconds, the optical path difference is about 1.5 m. Further, when the time difference is 5 microseconds, the optical path difference is about 1500 m. Therefore, there is a problem that the apparatus scale becomes too large. Further, since a large loss occurs while the laser light propagates through such a long optical path, there is also a problem that energy efficiency is low.

In the apparatus and the method described as the example in Patent Document 2, since the plurality of laser light sources respectively corresponding to the plurality of light pulses having different time widths are required, the number of laser light sources increases as the number of types of light pulses increases, which is a factor that hinders the size reduction and cost reduction of the laser processing apparatus.

An object of the present invention is to provide a laser processing apparatus and a laser processing method capable of reducing a size of a configuration in which a processing object is irradiated with a plurality of light pulses having different time waveforms.

### Solution to Problem

An embodiment of the present invention is a laser processing apparatus as defined in claim 1.

An embodiment of the present invention is a laser processing method as defined in claim 7.

In the above laser processing apparatus and the laser processing method, the waveform output unit outputs the input waveform data, and the driver circuit supplies the drive current having the time waveform according to the input waveform data to the semiconductor laser element. Therefore, by including an arbitrary time waveform in the input waveform data, a light pulse having an arbitrary time waveform can be output from the semiconductor laser element. Further, by including a plurality of pulse groups having a time difference in the input waveform data, a plurality of light pulse groups having a time difference can be output from the semiconductor laser element.

That is, according to the above apparatus and the method, it is possible to irradiate the processing object with the plurality of light pulse groups having different time waveforms with the time difference therebetween. In addition, since the plurality of light pulse groups are output from the single semiconductor laser element on a single optical path, the apparatus configuration can be reduced in size as compared with the methods described in Patent Documents 1 and 2.

### Advantageous Effects of Invention

According to the embodiments of the present invention, it is possible to provide a laser processing apparatus and a laser processing method capable of reducing a size of a configuration in which a processing object is irradiated with a plurality of light pulses having different time waveforms.

### Brief Description of Drawings

[FIG. 1] FIG. 1 is a block diagram schematically illustrating a configuration of a laser processing apparatus.
[FIG. 2] FIG. 2 is a block diagram illustrating a peripheral configuration of a semiconductor laser element 2, an optical amplifier 3, a driver circuit 4, and a waveform output unit 6.
[FIG. 3] FIG. 3 is a block diagram illustrating an example of the peripheral configuration of the semiconductor laser element 2, the optical amplifier 3, the driver circuit 4, and the waveform output unit 6.
[FIG. 4] FIG. 4 is a block diagram illustrating a detailed configuration example of the driver circuit 4.
[FIG. 5] FIG. 5 is a diagram schematically illustrating a function of a waveform timing adjustment unit 43.
[FIG. 6] FIG. 6 is a flowchart illustrating an operation of the laser processing apparatus 1A.
[FIG. 7] FIG. 7 includes (a) to (d) diagrams schematically illustrating light pulse waveforms.
[FIG. 8] FIG. 8 includes (a) a graph showing a time waveform of laser light La before amplification, and (b) a graph showing a time waveform of laser light Lb after amplification.
[FIG. 9] FIG. 9 includes (a) a graph showing a time waveform of the laser light La before amplification, and (b) a graph showing a time waveform of the laser light Lb after amplification.
[FIG. 10] FIG. 10 includes graphs showing examples of a time waveform of the laser light Lb output from the optical amplifier 3, and shows (a) a Gaussian waveform with a FWHM of 4 nanoseconds, and (b) a Gaussian waveform with a FWHM of 32 nanoseconds.
[FIG. 11] FIG. 11 includes graphs showing examples of a time waveform of the laser light Lb output from the optical amplifier 3, and shows (a) a rectangular waveform with a FWHM of 120 nanoseconds, and (b) a ramp waveform with a FWHM of 4 nanoseconds.
[FIG. 12] FIG. 12 is a graph showing a time waveform of a Gaussian pulse Pa with a pulse width of 23.7 ns (FWHM) generated as the laser light Lb in the laser processing apparatus 1A.
[FIG. 13] FIG. 13 includes (a) a front surface image of a processing object B after hole making processing observed by a SEM, and (b) a back surface image of the processing object B after the hole making processing observed by the SEM.
[FIG. 14] FIG. 14 is a graph showing a time waveform of a light pulse group Pb being a light pulse train including a plurality of ultrashort light pulses Pba generated as the laser light Lb in the laser processing apparatus 1A.
[FIG. 15] FIG. 15 includes (a) a front surface image of the processing object B after the hole making processing observed by the SEM, and (b) a back surface image of the processing object B after the hole making processing observed by the SEM.
[FIG. 16] FIG. 16 includes (a) a graph showing a time waveform of a light pulse group Pc and a light pulse Pd generated as the laser light Lb in the laser processing apparatus 1A, and (b) a front surface image of the processing object B after the hole making processing observed by the SEM.
[FIG. 17] FIG. 17 is a graph showing an example of a time waveform of the laser light Lb.
[FIG. 18] FIG. 18 includes graphs showing examples of a time waveform of the laser light Lb, and shows (a) a light pulse group Pf1 including a plurality of ultrashort light pulses Pfa and a light pulse group Pf2 including a single light pulse Pfb, and (b) a light pulse group Pg1 including a plurality of ultrashort light pulses Pga, a light pulse
[FIG. 19] FIG. 19 is a graph showing an example of a time waveform of the laser light Lb, and shows a light pulse group Ph1 including a single light pulse Pha and a light pulse group Ph2 including a single light pulse Phb.
[FIG. 20] FIG. 20 includes (a) to (c) diagrams conceptually showing various time waveforms which can be output from the laser processing apparatus 1A.
[FIG. 21] FIG. 21 includes (a) to (c) diagrams conceptually showing various time waveforms which can be output from the laser processing apparatus 1A.
[FIG. 22] FIG. 22 includes (a) to (c) diagrams conceptually showing various time waveforms which can be output from the laser processing apparatus 1A.
[FIG. 23] FIG. 23 includes (a) to (c) diagrams conceptually showing various time waveforms which can be output from the laser processing apparatus 1A.
[FIG. 24] FIG. 24 includes (a) to (c) diagrams conceptually showing various time waveforms which can be output from the laser processing apparatus 1A.
[FIG. 25] FIG. 25 is a graph showing an example in which a plurality of light pulse groups Pi, Pj, and Py corresponding to a plurality of processing processes are combined.
[FIG. 26] FIG. 26 shows a processing process in a case where a plurality of processing processes are continuously performed in a short time using the laser processing apparatus 1A, and shows (a) a processing object B having a plurality of layers B1 to B3 whose constituent materials are different from each other, and the laser light Lb with which the processing object B is irradiated, and (b) a time waveform of the laser light Lb.
[FIG. 27] FIG. 27 shows a processing process in the case where the plurality of processing processes are continuously performed in a short time using the laser processing apparatus 1A, and shows (a) the processing object B having the plurality of layers B1 to B3 whose constituent materials are different from each other, and the laser light Lb with which the processing object B is irradiated, and (b) a time waveform of the laser light Lb.
[FIG. 28] FIG. 28 shows a processing process in the case where the plurality of processing processes are continuously performed in a short time using the laser processing apparatus 1A, and shows (a) the processing object B having the plurality of layers B1 to B3 whose constituent materials are different from each other, and the laser light Lb with which the processing object B is irradiated, and (b) a time waveform of the laser light Lb.
[FIG. 29] FIG. 29 shows a processing process in the case where the plurality of processing processes are continuously performed in a short time using the laser processing apparatus 1A, and shows (a) the processing object B having the plurality of layers B1 to B3 whose constituent materials are different from each other, and the laser light Lb with which the processing object B is irradiated, and (b) a time waveform of the laser light Lb.
[FIG. 30] FIG. 30 includes (a) a graph showing a combination of light pulse groups Pi, Py, and Pk corresponding to a certain processing process, (b) a graph showing a light pulse group Pj corresponding to a next processing process, and (c) a graph showing light pulse groups Pi, Pi, and Pm corresponding to a further next processing process.
[FIG. 31] FIG. 31 is a graph showing a time waveform of the laser light Lb with which irradiation is performed in an example.
[FIG. 32] FIG. 32 includes (a), (b) diagrams showing SEM images of a hole formed in the processing object B.
[FIG. 33] FIG. 33 includes (a), (b) diagrams showing SEM images of a hole formed in the processing object B.
[FIG. 34] FIG. 34 is a block diagram illustrating a configuration of an embodiment of the invention.
[FIG. 35] FIG. 35 is a graph showing an example of a plurality of light pulse groups with which the processing object B is irradiated in the embodiment.

### Description of Embodiments

Hereinafter, embodiments of a laser processing apparatus and a laser processing method will be described in detail with reference to the accompanying drawings. In the description of the drawings, the same elements will be denoted by the same reference signs, and redundant description will be omitted. Further, the present invention is not limited to these examples.

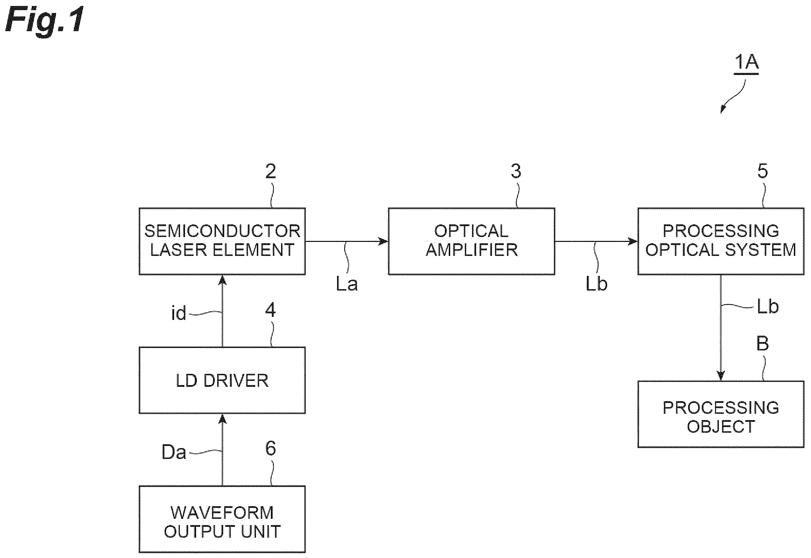

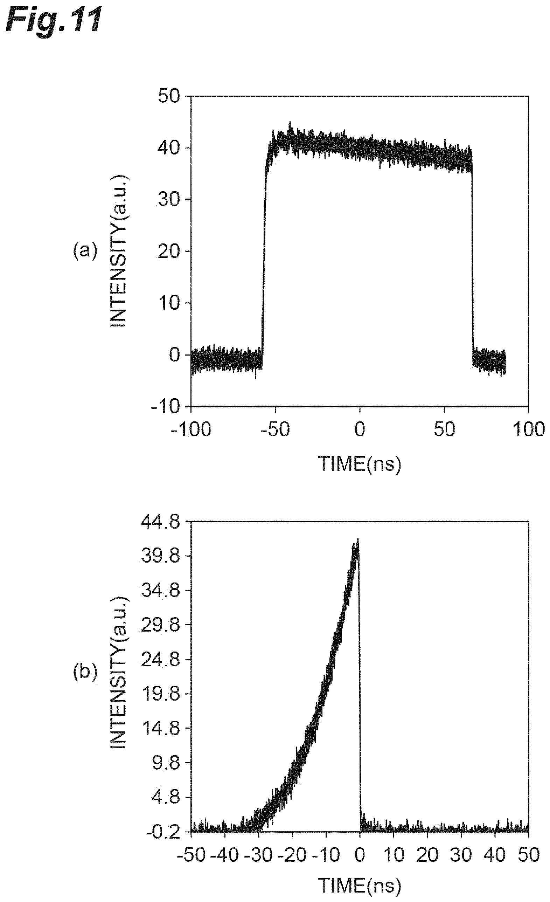

FIG. 1 is a block diagram schematically illustrating a configuration of a laser processing apparatus according to an example not falling within the scope of the claims. As illustrated in FIG. 1, the laser processing apparatus 1A of the present example includes a semiconductor laser element 2, an optical amplifier 3, a driver circuit 4, a processing optical system 5, and a waveform output unit 6. The waveform output unit 6 is constituted by an electronic circuit, and is electrically connected to the driver circuit 4. The waveform output unit 6 calculates and generates input waveform data Da for bringing a time waveform of a light pulse output from the optical amplifier 3 close to a target waveform, and provides the input waveform data Da to the driver circuit 4.

An input end of the driver circuit 4 is electrically connected to the waveform output unit 6, and receives the input waveform data Da from the waveform output unit 6. The driver circuit 4 generates a drive current id having a time waveform according to the input waveform data Da. An output end of the driver circuit 4 is electrically connected to the semiconductor laser element 2, and supplies the generated drive current id to the semiconductor laser element 2. In addition, a bias current having a constant magnitude without time change may be superimposed on the drive current id.

The semiconductor laser element 2 is a laser diode, and is electrically connected to the driver circuit 4. The driver circuit 4 supplies the drive current id to any one of a cathode and an anode of the semiconductor laser element 2. The semiconductor laser element 2 receives the drive current id and generates laser light La. The laser light La is light before amplification by the optical amplifier 3, and has a time waveform according to the input waveform data Da.

In one example, the semiconductor laser element 2 is a distributed feedback (DFB) laser diode. When the semiconductor laser element 2 is a DFB laser diode, optimization according to a wavelength property of a gain of the optical amplifier 3 can be easily performed. An output power of the semiconductor laser element 2 is, for example, several nanojoules.

A light input end of the optical amplifier 3 is optically coupled to the semiconductor laser element 2, and amplifies the laser light La output from the semiconductor laser element 2. The optical amplifier 3 does not convert the laser light La into an electric signal, and directly amplifies the light as it is. The optical amplifier 3 may be constituted by, for example, an optical fiber amplifier, a solid-state laser amplifier, or a combination thereof.

The optical fiber amplifier includes an optical fiber made of glass with added impurities such as Er or Yb, and amplifies the laser light La by inputting excitation light to the optical fiber together with or prior to the laser light La. Further, the solid-state laser amplifier may include glass, yttrium aluminum garnet (YAG), or neodymium yttrium orthovanadate (YVO₄) with added impurities such as Nd. The solid-state laser amplifier amplifies the laser light La by inputting excitation light together with or prior to the laser light La. The gain of the optical amplifier 3 is, for example, within a range of 3 dB to 30 dB.

The processing optical system 5 includes an optical path extending from an output end of the optical amplifier 3 and a focusing optical system provided on the optical path. The laser light Lb after the amplification output from the optical amplifier 3 propagates through the optical path of the processing optical system 5 to reach the focusing optical system, and is focused by the focusing optical system and applied to a processing object B.

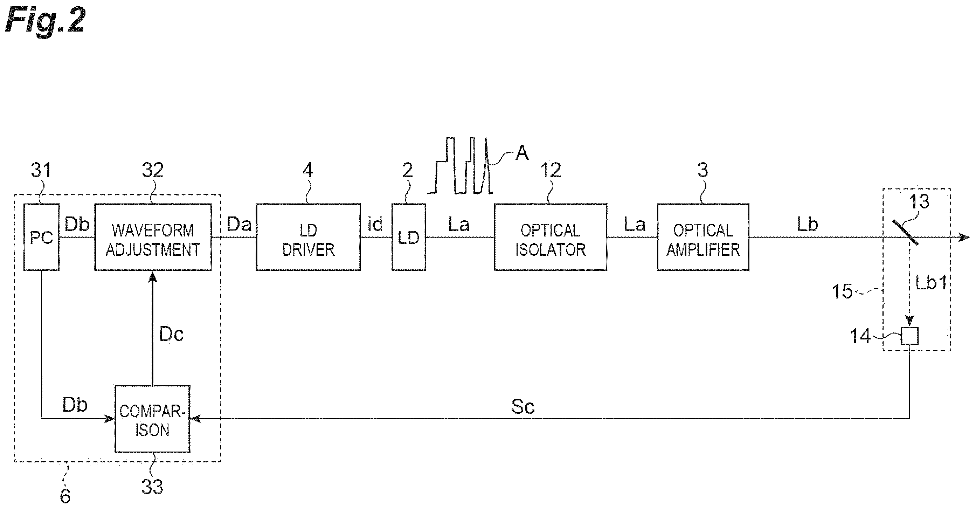

FIG. 2 is a block diagram illustrating a peripheral configuration of the semiconductor laser element 2, the optical amplifier 3, the driver circuit 4, and the waveform output unit 6. In addition, a waveform A in the diagram schematically shows a time waveform of the laser light La output from the semiconductor laser element 2. As illustrated in FIG. 2, the waveform output unit 6 includes a computer 31, a waveform adjustment unit 32, and a comparison unit 33.

The computer 31 includes a CPU and a memory, and operates according to a program stored in the memory. The memory of the computer 31 is a storage unit in the present example, and stores data representing a desired (arbitrary) time waveform, that is, a target waveform (hereinafter referred to as target waveform data) in advance.

The target waveform data is stored in the memory in advance by an operator through a data input terminal of the computer 31 before the operation of the laser processing apparatus 1A. Further, the computer 31 may design the target waveform by itself as a waveform design unit. That is, the computer 31 may calculate a target waveform for achieving light irradiation conditions (processing conditions, observation conditions) given from the outside. The target waveform data representing the calculated target waveform is stored in the memory of the computer 31.

The comparison unit 33 is electrically connected to a photodetection unit 14 to be described later, and acquires a time waveform of the laser light Lb based on a detection signal (light intensity signal Sc) obtained from the photodetection unit 14. Further, the comparison unit 33 is electrically connected to the computer 31, and acquires the target waveform data Db from the computer 31. The comparison unit 33 compares the time waveform of the laser light Lb with the target waveform, and sends difference data Dc representing the difference to the waveform adjustment unit 32.

In addition, the comparison unit 33 may be constituted by a computer including a CPU and a memory. In this case, the comparison unit 33 may be provided separately from the computer 31, or may be implemented in a computer in common with the computer 31.

The waveform adjustment unit 32 is electrically connected to the computer 31, and acquires the target waveform data Db from the computer 31. Further, the waveform adjustment unit 32 is electrically connected to the comparison unit 33, and acquires the difference data Dc output from the comparison unit 33. The waveform adjustment unit 32 generates the input waveform data Da so that the time waveform of the laser light Lb approaches the target waveform (that is, the difference becomes small) based on the data Db and Dc.

In addition, the waveform adjustment unit 32 may also be constituted by a computer including a CPU and a memory. In this case, the waveform adjustment unit 32 may be provided separately from the computer 31 and the comparison unit 33, or may be implemented in a computer in common with at least one of the computer 31 and the comparison unit 33.

The laser processing apparatus 1A illustrated in FIG. 2 further includes an optical isolator 12, an optical branch unit 13, and the photodetection unit 14. A light input end of the optical isolator 12 is optically coupled to a laser light output end of the semiconductor laser element 2. Further, a light output end of the optical isolator 12 is optically coupled to a light input end of the optical amplifier 3. That is, the optical isolator 12 is interposed on an optical path between the semiconductor laser element 2 and the optical amplifier 3. The optical isolator 12 prevents the light amplified by the optical amplifier 3 from returning to the semiconductor laser element 2.

The optical branch unit 13 and the photodetection unit 14 constitute a light waveform detection unit 15. The light waveform detection unit 15 detects the time waveform of the laser light Lb after the amplification output from the optical amplifier 3. The optical branch unit 13 is optically coupled to a light output end of the optical amplifier 3. The optical branch unit 13 branches a part Lb1 of the laser light Lb after the amplification from the laser light Lb by reflecting (or transmitting) the part Lb1 of the laser light Lb after the amplification output from the optical amplifier 3. The optical branch unit 13 may be constituted by, for example, a glass plate.

A ratio (branching ratio) P1/P2 of an intensity P1 of the part Lb1 of the laser light Lb and an intensity P2 of the remaining part is, for example, within a range of 0.005 to 0.01. The photodetection unit 14 is optically coupled to the optical branch unit 13, and receives the part Lb1 of the laser light Lb after the amplification. In addition, the remaining part of the laser light Lb is applied to the processing object B through the processing optical system 5 illustrated in FIG. 1.

The photodetection unit 14 generates the light intensity signal Sc being an electric signal according to the light intensity of the part Lb1 of the laser light Lb, and provides the light intensity signal Sc to the comparison unit 33. In one example, the photodetection unit 14 may be constituted by including a photodiode and a circuit for converting a photocurrent flowing through the photodiode into a voltage signal.

The photodetection unit 14 may output the generated voltage signal as the light intensity signal Sc, or may convert the generated voltage signal into a digital signal and output the digital signal as the light intensity signal Sc. When the light intensity signal Sc is the voltage signal, it is converted into the digital signal in the comparison unit 33. In addition, the photodetection unit 14 may include a phototube (for example, a biplanar phototube) instead of the photodiode.

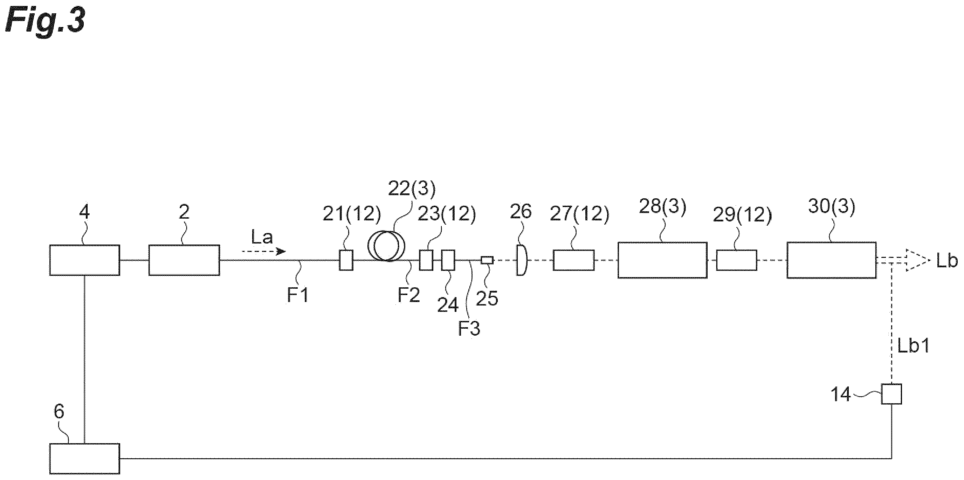

FIG. 3 is a block diagram illustrating a specific example of the peripheral configuration of the semiconductor laser element 2, the optical amplifier 3, the driver circuit 4, and the waveform output unit 6. In the specific example illustrated in FIG. 3, the laser processing apparatus 1A includes optical isolators 21, 23, 27, and 29 as the optical isolator 12 illustrated in FIG. 2, an optical fiber amplifier 22 and solid-state laser amplifiers 28 and 30 as the optical amplifier 3. As described above, in the present specific example, the optical amplifier 3 is configured in multiple stages. In addition, the laser processing apparatus 1A includes a bandpass filter 24, an optical fiber connector 25, and a collimator lens 26.

A light input end of the optical fiber amplifier 22 and the semiconductor laser element 2 are optically coupled via an optical fiber F1. The optical isolator 21 is interposed between the optical fiber amplifier 22 and the semiconductor laser element 2. The optical isolator 21 prevents the light (laser light La and excitation light) from returning from the optical fiber amplifier 22 to the semiconductor laser element 2. Thus, damage to the semiconductor laser element 2 can be prevented.

A light output end of the optical fiber amplifier 22 and the bandpass filter 24 are optically coupled via an optical fiber F2. The optical isolator 23 is interposed between the optical fiber amplifier 22 and the bandpass filter 24. The optical isolator 23 prevents the light at a stage after the bandpass filter 24 from returning to the optical fiber amplifier 22.

The optical fiber amplifier 22 is a first stage optical amplifier, and amplifies the laser light La output from the semiconductor laser element 2. The gain of the optical fiber amplifier 22 is, for example, within a range of 20 dB to 30 dB. The optical fiber amplifier 22 is, for example, an ytterbium-doped fiber (YDF). The bandpass filter 24 blocks a wavelength component of fluorescence contained in the light output from the optical fiber amplifier 22. The bandpass filter 24 may be constituted by, for example, a dielectric multilayer film.

The bandpass filter 24 is optically coupled to the optical fiber connector 25 via an optical fiber F3. The optical fiber connector 25 terminates the optical fiber F3. That is, the light passing through the bandpass filter 24 propagates through the optical fiber F3, reaches the optical fiber connector 25, and then is output to a space.

The collimator lens 26 is optically coupled to the optical fiber connector 25 via the space, and parallelizes (collimates) the light radially output from the optical fiber connector 25. Since an intensity of light amplified by the solid-state laser amplifiers 28 and 30 to be described later is high, in order to avoid damage by the laser to an optical material such as glass, the light is propagated in the space instead of in an optical fiber at a stage after the optical fiber connector 25. In addition, in FIG. 3, the light propagating in the space is illustrated by a dashed line.

The solid-state laser amplifier 28 is optically coupled to the collimator lens 26 via the optical isolator 27. The optical isolator 27 prevents the light of the solid-state laser amplifier 28 from returning to a stage before the solid-state laser amplifier 28. Thus, damage to the optical fiber amplifier 22 can be prevented.

The solid-state laser amplifier 28 is a second stage optical amplifier, and further amplifies the laser light after the amplification output from the optical fiber amplifier 22. The gain of the solid-state laser amplifier 28 is, for example, within a range of 3 dB to 20 dB.

The solid-state laser amplifier 30 is optically coupled to the solid-state laser amplifier 28 via the optical isolator 29. That is, the optical fiber amplifier 22 and the solid-state laser amplifiers 28 and 30 are coupled in series with each other. The optical isolator 29 prevents the light of the solid-state laser amplifier 30 from returning to a stage before the solid-state laser amplifier 30. Thus, damage to the solid-state laser amplifier 28 can be prevented.

The solid-state laser amplifier 30 is a third stage optical amplifier, and further amplifies the laser light after the amplification output from the solid-state laser amplifier 28. The gain of the solid-state laser amplifier 30 is, for example, within a range of 3 dB to 10 dB. The light amplified by the solid-state laser amplifier 30 is output as the laser light Lb after the amplification.

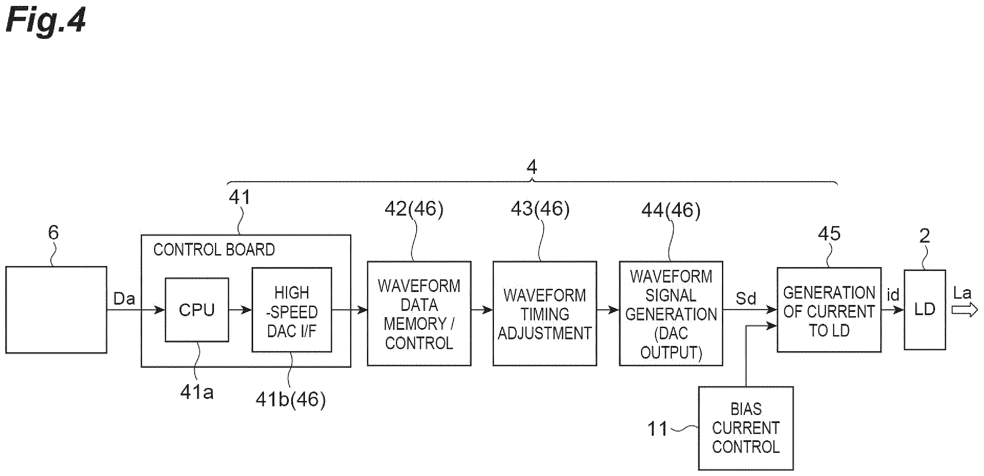

FIG. 4 is a block diagram illustrating a detailed configuration example of the driver circuit 4. As illustrated in FIG. 4, the driver circuit 4 includes a control board 41, a waveform data storage unit 42, a waveform timing adjustment unit 43, a waveform signal generation unit 44, and a current conversion unit 45. Further, the control board 41 is constituted by including a CPU 41a and a high-speed DAC interface 41b. Of these, the high-speed DAC interface 41b, the waveform data storage unit 42, the waveform timing adjustment unit 43, and the waveform signal generation unit 44 constitute a D/A conversion unit 46. The D/A conversion unit 46 is an electronic circuit, and converts the digital input waveform data Da into an analog drive signal Sd.

The control board 41 is a circuit board serving as an interface with the waveform output unit 6. The CPU 41a is electrically connected to the waveform adjustment unit 32 (see FIG. 2) of the waveform output unit 6 via a communication line, and receives the input waveform data Da from the waveform adjustment unit 32. The CPU 41a transmits the input waveform data Da to the high-speed DAC interface 41b at an appropriate timing. The high-speed DAC interface 41b temporarily stores the input waveform data Da in the waveform data storage unit 42. The waveform data storage unit 42 is electrically connected to the high-speed DAC interface 41b, and is constituted by, for example, a volatile storage element.

The waveform adjustment unit 32 of the present example outputs the input waveform data Da as a plurality of continuous section waveform data obtained by dividing the time waveform of the input waveform data Da (details will be described later). These section waveform data are output in parallel and simultaneously for every two or more section waveform data. Then, the waveform data storage unit 42 stores the plurality of section waveform data, and outputs the plurality of section waveform data according to a request.

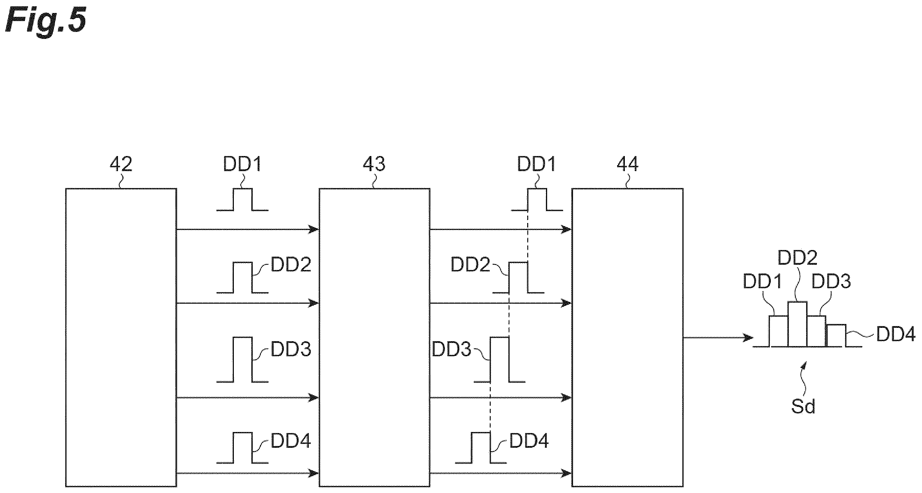

The waveform timing adjustment unit 43 is electrically connected to the waveform data storage unit 42, and adjusts (controls) a timing at which the input waveform data Da is output from the waveform data storage unit 42. FIG. 5 is a diagram schematically illustrating a function of the waveform timing adjustment unit 43. As illustrated in FIG. 5, the waveform timing adjustment unit 43 sequentially outputs the plurality of section waveform data DD1 to DD4 read from the waveform data storage unit 42 while giving an appropriate time difference. In addition, the appropriate time difference is, for example, a time width of each section waveform data. The time width defines a time resolution of the output waveform, and is 1 nanosecond in one example.

The waveform signal generation unit 44 sequentially inputs the plurality of section waveform data DD1 to DD4 output from the waveform timing adjustment unit 43, and sequentially converts the section waveform data DD1 to DD4 into the drive signal Sd being an analog signal (voltage signal). In this case, a time difference between conversion timings of the section waveform data DD1 to DD4 substantially coincides with the time difference given by the waveform timing adjustment unit 43.

FIG. 4 is referred again. The current conversion unit 45 is electrically connected to the waveform signal generation unit 44, and converts the drive signal Sd into the drive current id. That is, the current conversion unit 45 is constituted by an analog circuit including a transistor, and converts the drive signal Sd being a voltage signal into the drive current id being a current signal. The time waveform of the generated drive current id is substantially the same as the time waveform of the drive signal Sd.

In addition, the current conversion unit 45 is further connected to a bias current control unit 11. The bias current control unit 11 controls a magnitude of a bias component contained in the drive current id. The semiconductor laser element 2 is electrically connected to a current output end of the current conversion unit 45, receives the drive current id from the current conversion unit 45, and outputs the laser light La. The time waveform of the laser light La is substantially the same as the time waveform of the drive current id.

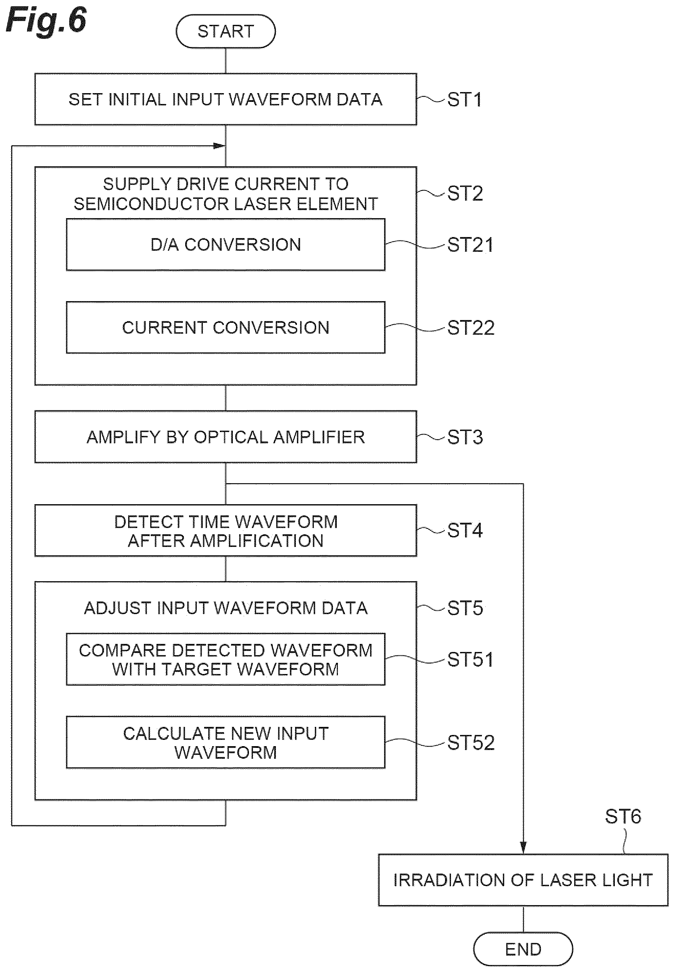

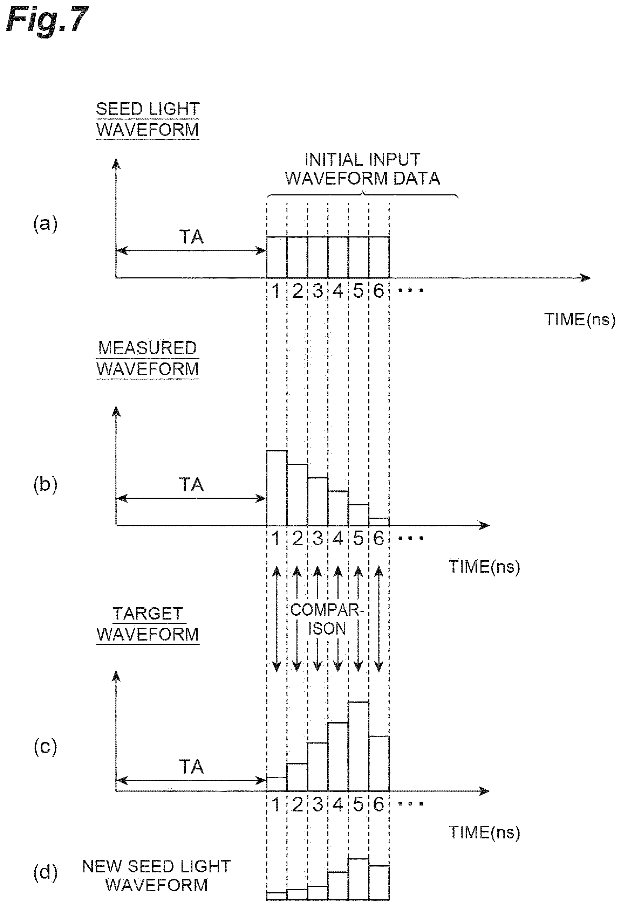

FIG. 6 is a flowchart illustrating an operation of the laser processing apparatus 1A. Further, (a) to (d) in FIG. 7 are diagrams schematically illustrating light pulse waveforms. In these diagrams, the time waveform of the light pulse is illustrated as a set of peak values (light intensities) of a plurality of continuous unit sections. A delay time TA is set as necessary, and a start point of the time waveform of the light pulse is delayed by the delay time TA from a reference time. In (a) to (d) in FIG. 7, the vertical axis indicates the light intensity, and the horizontal axis indicates the time. The operation of the laser processing apparatus 1A and the laser processing method of the present embodiment will be described with reference to FIG. 6 and FIG. 7.

First, the waveform adjustment unit 32 sets initial input waveform data Da (step ST1). The initial input waveform data Da is set based on the target waveform data Db. In one example, the target waveform data Db is used as it is as the initial input waveform data Da. Next, the driver circuit 4 supplies the drive current id to the semiconductor laser element 2 based on the initial input waveform data Da, and the semiconductor laser element 2 outputs the laser light La (current supply step ST2). (a) in FIG. 7 schematically illustrates a time waveform of the laser light La generated based on the initial input waveform data Da. The laser light La is amplified by the optical amplifier 3 (optical amplification step ST3).

In addition, the current supply step ST2 includes a D/A conversion step ST21 and a current conversion step ST22. In the D/A conversion step ST21, the D/A conversion unit 46 converts the digital input waveform data Da into the analog drive signal Sd. In this case, as described above, the plurality of continuous section waveform data DD1 to DD4 (see FIG. 5) obtained by dividing the time waveform of the input waveform data Da are sequentially converted into the drive signal Sd while giving the time difference. In the current conversion step ST22, the current conversion unit 45 converts the drive signal Sd into the drive current id.

Subsequently, the time waveform of the laser light Lb after the amplification is detected by the photodetection unit 14 (light waveform detection step ST4). (b) in FIG. 7 schematically illustrates the detected time waveform. In many cases, the time waveform of the laser light Lb after the amplification is different from the time waveform of the laser light La before the amplification. One of causes is that an excited state in the optical amplifier 3 changes with the passage of time. That is, immediately after the incidence of the laser light La, the optical amplifier 3 is strongly excited, and amplifies the laser light La with high gain. However, when time elapses from the start of the incidence of the laser light La, an excitation strength of the optical amplifier 3 gradually decreases, and the amplification gain of the laser light La also decreases accordingly.

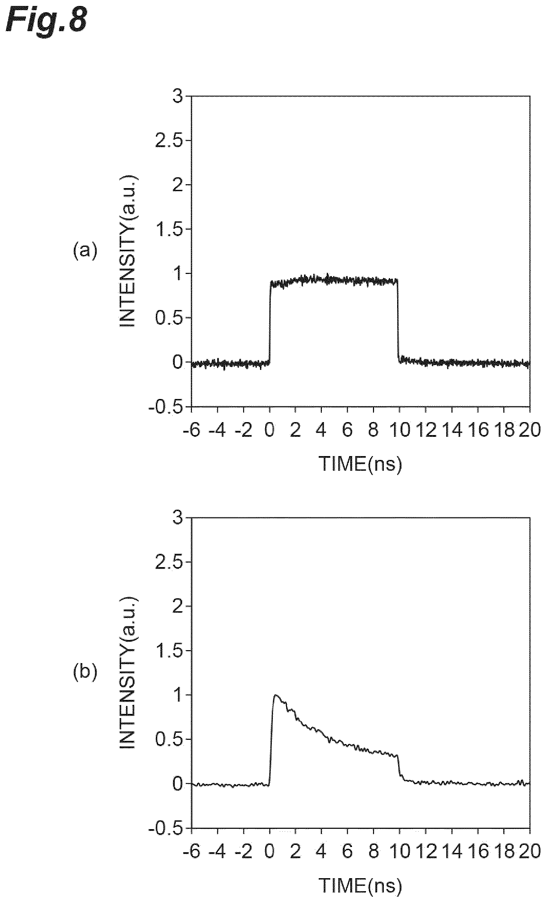

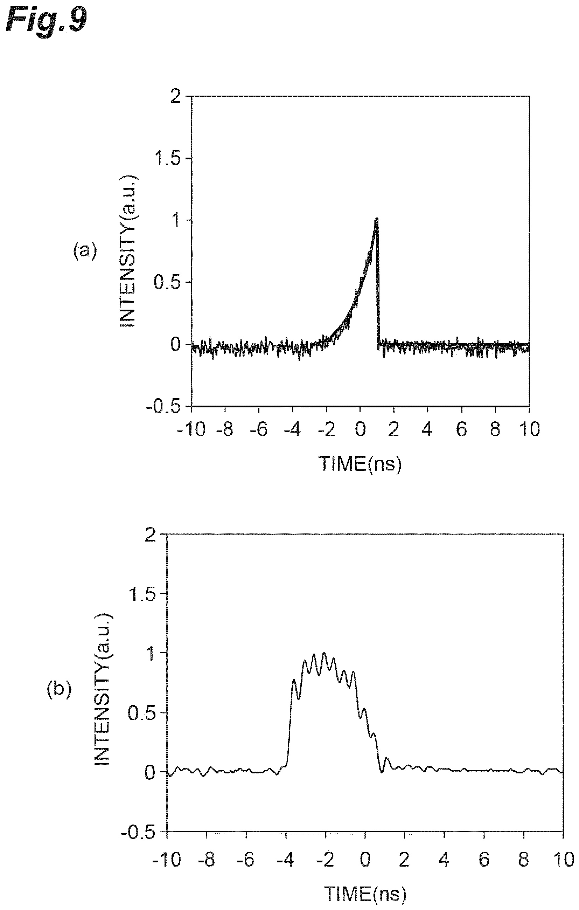

FIG. 8 and FIG. 9 include graphs respectively showing time waveforms of the laser light La before the amplification and the laser light Lb after the amplification, which are actually measured. (a) in FIG. 8 shows a time waveform (rectangular wave) of the laser light La before the amplification, and (b) in FIG. 8 shows a time waveform of the laser light Lb after amplifying the laser light La having the time waveform shown in (a) in FIG. 8. Further, (a) in FIG. 9 shows a time waveform (ramp wave) of the laser light La before the amplification, and (b) in FIG. 9 shows a time waveform of the laser light Lb after amplifying the laser light La having the time waveform shown in (a) in FIG. 9. In addition, the vertical axis indicates the light intensity (arb. unit), and the horizontal axis indicates the time (unit: nanosecond). As shown in these figures, the time waveform of the laser light Lb after the amplification is greatly different from the time waveform of the laser light La before the amplification.

FIG. 7 is referred again. In a waveform adjustment step ST5, first, the comparison unit 33 compares the detected time waveform of the laser light Lb with the target waveform represented by the target waveform data Db ((c) in FIG. 7), and outputs the difference (error) (step ST51). Next, the waveform adjustment unit 32 adjusts the time waveform of the input waveform data Da based on the difference. That is, the waveform adjustment unit 32 calculates new input waveform data Da so that the difference becomes smaller (that is, the difference approaches 0) (step ST52).

The driver circuit 4 supplies the drive current id to the semiconductor laser element 2 based on the new input waveform data Da, and the semiconductor laser element 2 outputs the laser light La (current supply step ST2). (d) in FIG. 7 schematically illustrates a time waveform of the laser light La generated based on the new input waveform data Da. The laser light La is amplified by the optical amplifier 3 (optical amplification step ST3). By repeating the above steps ST2 to ST5, the time waveform of the laser light Lb after the amplification approaches the target waveform. The laser light Lb thus generated is applied to the processing object B through the processing optical system 5 illustrated in FIG. 1 (light irradiation step ST6).

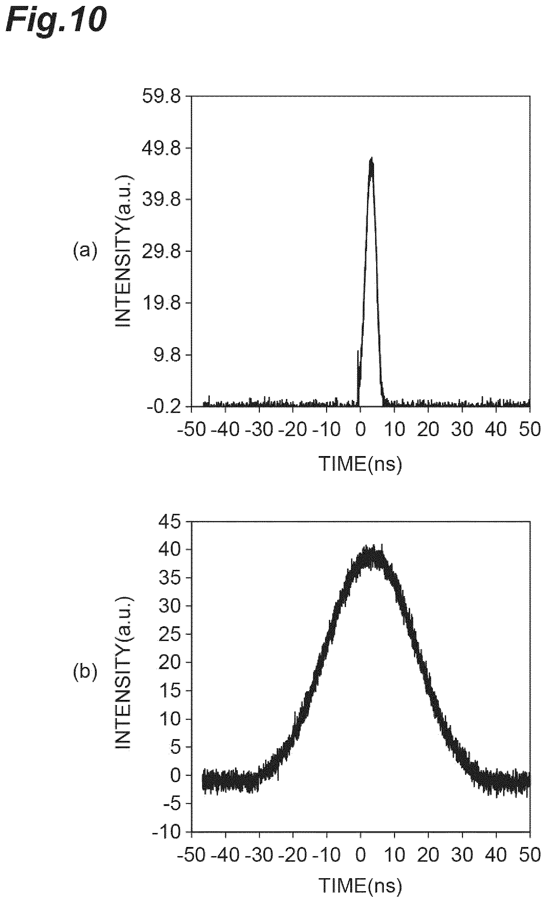

FIG. 10 and FIG. 11 include graphs showing examples of the time waveform of the laser light Lb output from the optical amplifier 3. In addition, the vertical axis indicates the light intensity (arb. unit), and the horizontal axis indicates the time (unit: nanosecond). (a) in FIG. 10 shows a Gaussian waveform with a full width at half maximum (FWHM) of 4 nanoseconds. (b) in FIG. 10 shows a Gaussian waveform with a FWHM of 32 nanoseconds. (a) in FIG. 11 shows a rectangular wave with a FWHM of 120 nanoseconds. (b) in FIG. 11 shows a ramp waveform with a FWHM of 4 nanoseconds. As described above, according to the laser processing apparatus 1A of the present example, any various time waveforms can be generated.

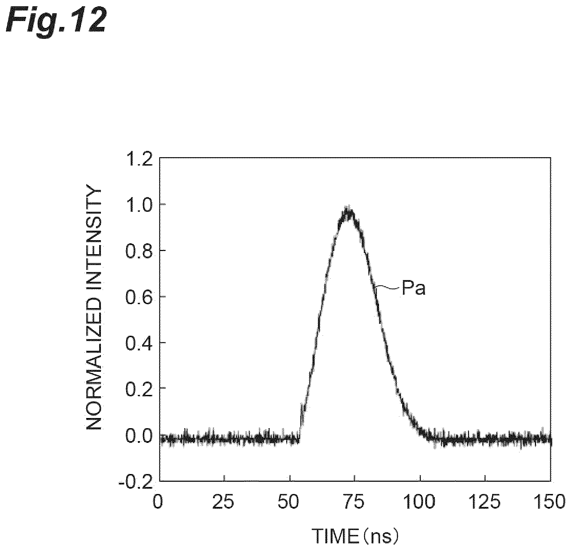

A preferred time waveform of the laser light Lb will be further discussed. FIG. 12 is a graph showing a time waveform (measured value) of a Gaussian pulse Pa with a pulse width of 23.7 ns (FWHM) generated as the laser light Lb in the laser processing apparatus 1A of the present example. In FIG. 12, the vertical axis indicates the normalized intensity (arb. unit), and the horizontal axis indicates the time (unit: nanosecond). The processing object B was irradiated with the above laser light Lb to perform hole making processing.

In addition, a wavelength of the laser light Lb was set to 1064 nm, a repetition frequency of the light pulse Pa was set to 300 Hz, and the irradiation was performed for 3 seconds (that is, the number of times of irradiation of the light pulse Pa was 900), a pulse energy of the light pulse Pa was set to 40 µJ, and a plano-convex lens with a focal length of 40 mm was used as the focusing lens of the processing optical system 5. Further, the processing object B was set to 50 µm thick stainless steel (SUS304), and a focusing diameter of the laser light Lb on the processing object B was set to 10 µm.

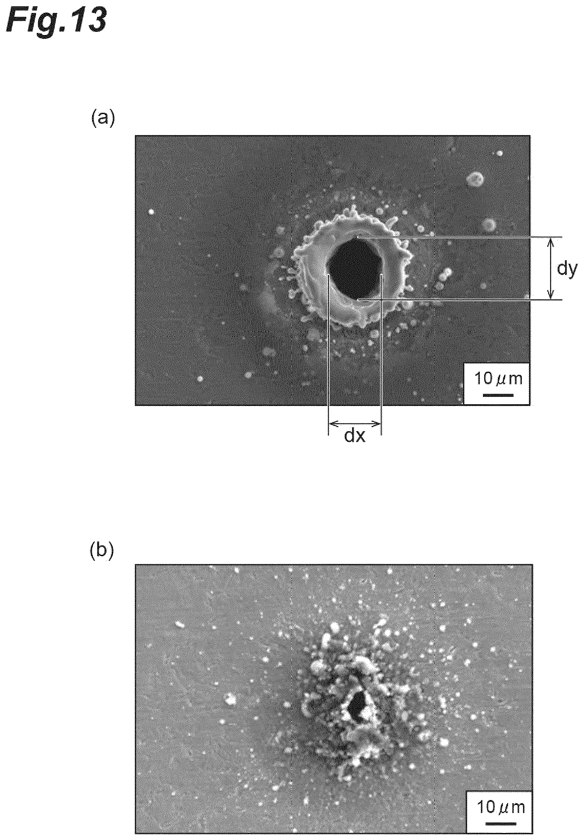

(a) in FIG. 13 is an image of a front surface (laser irradiation surface) of the processing object B after the hole making processing observed by a scanning electron microscope (SEM). (b) in FIG. 13 is an image of a back surface of the processing object B after the hole making processing observed by the SEM. Referring to FIG. 13, it can be seen that a substantially circular through hole is formed in the processing object B. When a diameter of the hole on the front surface of the processing object B was measured, a width dx in the horizontal direction of the paper plane was 19.1 µm, and a width dy in the vertical direction of the paper plane was 21.4 µm. That is, the hole having the size of about twice the focusing diameter of the laser light Lb was formed.

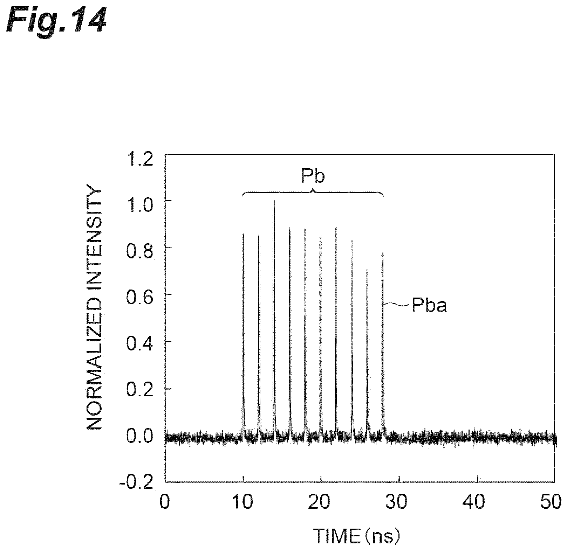

FIG. 14 is a graph showing a time waveform (measured value) of a light pulse group Pb being a light pulse train including a plurality of ultrashort light pulses Pba generated as the laser light Lb in the laser processing apparatus 1A of the present example. In FIG. 14, the vertical axis indicates the normalized intensity (arb. unit), and the horizontal axis indicates the time (unit: nanosecond). The processing object B was irradiated with the above laser light Lb to perform the hole making processing.

In addition, a pulse width of each ultrashort light pulse Pba included in the light pulse group Pb was set to 70 ps (FWHM), a time interval between the pulses was set to 2 ns, and the number of the ultrashort light pulses Pba was set to 10. Further, a repetition frequency of the light pulse group Pb was set to 300 Hz, and the irradiation was performed for 3 seconds (that is, the number of times of irradiation of the light pulse group Pb was 900), and a pulse energy of each ultrashort light pulse Pba was set to 40 µJ. The wavelength of the laser light Lb, the focusing lens of the processing optical system 5, the material of the processing object B, and the focusing diameter of the laser light Lb were the same as described above.

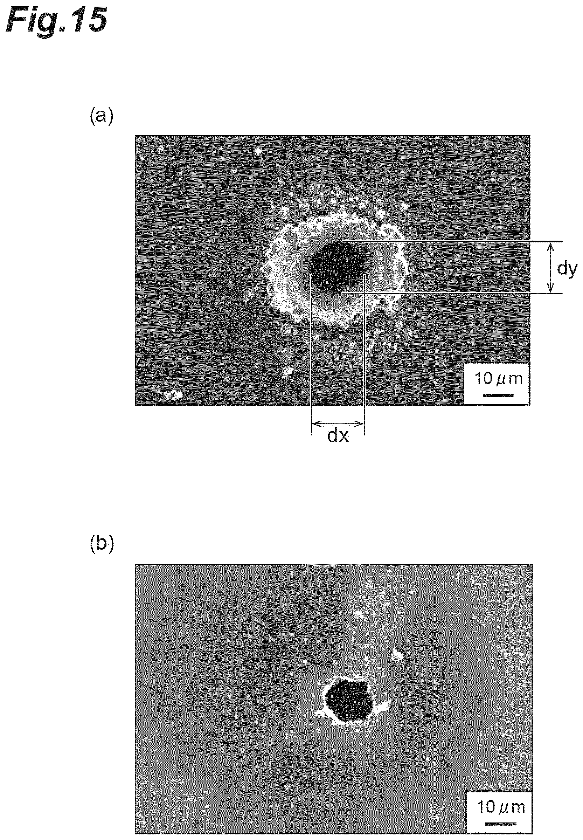

(a) in FIG. 15 is an image of the front surface (laser irradiation surface) of the processing object B after the hole making processing observed by the SEM. (b) in FIG. 15 is an image of the back surface of the processing object B after the hole making processing observed by the SEM. Referring to FIG. 15, it can be seen that a substantially circular through hole is formed in the processing object B also in this example. When a diameter of the hole on the front surface of the processing object B was measured, a width dx in the horizontal direction of the paper plane was 28.6 µm, and a width dy in the vertical direction of the paper plane was 25.4 µm. That is, the hole larger than in the case of the Gaussian pulse Pa shown in FIG. 12 was formed.

The peak output of the Gaussian pulse Pa shown in FIG. 12 was 2.15 GW/cm². On the other hand, since the plurality of ultrashort light pulses Pba shown in FIG. 14 have the pulse width smaller than that of the Gaussian pulse Pa, the peak output thereof was about 30 times (60 GW/cm²) the peak output of the Gaussian pulse Pa. Therefore, in FIG. 15, it is estimated that the diameter of the hole is increased due to the ablation being further promoted and the processing rate being increased.

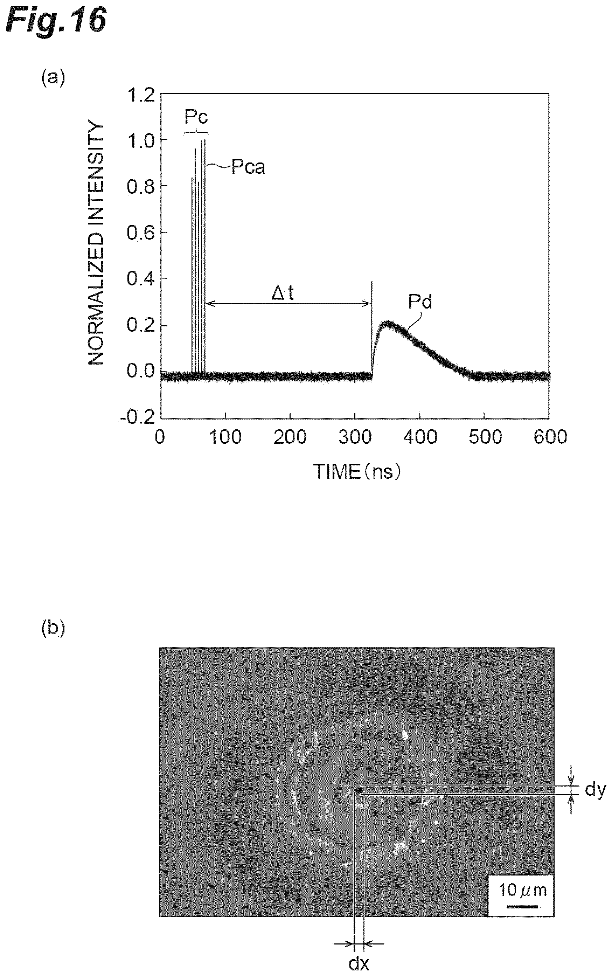

(a) in FIG. 16 is a graph showing a time waveform (measured value) of a light pulse group Pc and a light pulse Pd generated as the laser light Lb in the laser processing apparatus 1A of the present example. In (a) in FIG. 16, the vertical axis indicates the normalized intensity (arb. unit), and the horizontal axis indicates the time (unit: nanosecond). The processing object B was irradiated with the above laser light Lb to perform the hole making processing.

In addition, the light pulse group Pc includes a plurality of ultrashort light pulses Pca, and is the same as the light pulse group Pb shown in FIG. 14 in which the number of the ultrashort light pulses Pba is set to 5, which is the half. The light pulse Pd is a single pulse with a pulse width of 71 ns. A time interval Δt between the light pulse group Pc and the light pulse Pd is set to 260.1 ns. The wavelength and the pulse energy of the laser light Lb, the focusing lens of the processing optical system 5, the material of the processing object B, and the focusing diameter of the laser light Lb were the same as described above.

(b) in FIG. 16 is an image of the front surface (laser irradiation surface) of the processing object B after the hole making processing observed by the SEM. In addition, in this example, the hole did not penetrate to the back surface of the processing object B. Referring to (b) in FIG. 16, it can be seen that a substantially circular small depressed portion is formed on the front surface of the processing object B. When a diameter of the depressed portion on the front surface of the processing object B was measured, a width dx in the horizontal direction of the paper plane was 2.5 µm, and a width dy in the vertical direction of the paper plane was 2.4 µm. That is, the depressed portion having the diameter much smaller than the focusing diameter of the laser light Lb was formed.

The above depressed portion having the diameter much smaller than the focusing diameter of the laser light Lb is considered to be obtained as a result of processing by the light pulse group Pc including the plurality of ultrashort light pulses Pca having the time width of a picosecond order and processing by the light pulse Pd having the time width of a nanosecond order being performed in a combined manner. More specifically, it is estimated that hole processing is progressed by the light pulse group Pc having a high peak output, and thermal processing is progressed by energy irradiation for a long time through the light pulse Pd having a low peak output, and as a result, the processing object B (SUS304) is moderately melted, and the depressed portion with the small diameter is formed.

The example shown in FIG. 16 suggests that the processing object B is irradiated with two or more light pulse groups each including one or a plurality of light pulses with a time interval Δt therebetween, and time waveforms of at least two light pulse groups out of the two or more light pulse groups are different from each other, thereby enabling various types of processing that have been considered difficult conventionally. Further, the above irradiation configuration is realized by providing, from the driver circuit 4 to the semiconductor laser element 2 in the current supply step ST2, the drive current id in which two or more pulse groups each including one or a plurality of pulses are provided with the time interval Δt therebetween, and time waveforms of at least two pulse groups out of the two or more pulse groups are different from each other.

In addition, the time waveform used here is a concept including at least one of a time waveform of each of the one or plurality of pulses in each pulse group, a time width of each of the one or plurality of pulses in each pulse group, and a time interval of the plurality of pulses in each pulse group. The time interval Δt is, for example, 200 microseconds or less, and more preferably 1 microsecond or less.

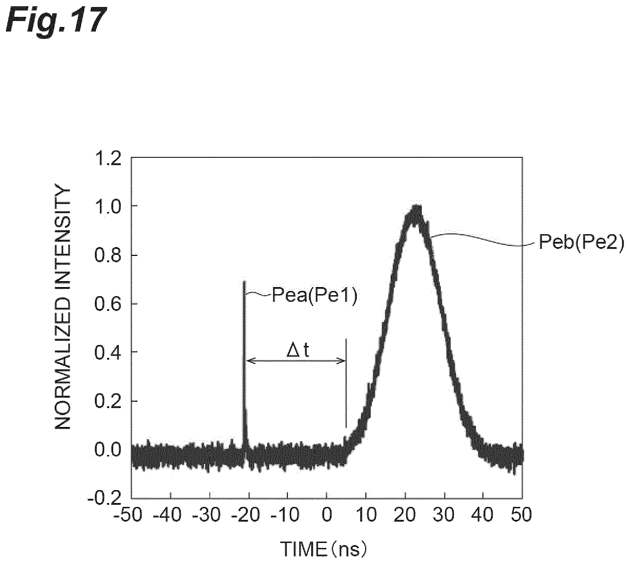

FIG. 17 is a graph (measured value) showing another example of a time waveform of the laser light Lb in the above irradiation configuration. In FIG. 17, the vertical axis indicates the normalized intensity (arb. unit), and the horizontal axis indicates the time (unit: nanosecond). In this example, a light pulse group Pe1 including a single light pulse Pea and a light pulse group Pe2 including a single light pulse Peb are output from the optical amplifier 3. The light pulses Pea and Peb are both Gaussian pulses, and time widths (FWHM) are 62 ps and 15 ns, respectively. A time interval Δt between the light pulse group Pe1 and the light pulse group Pe2 is 25.8 ns.

According to the laser processing apparatus 1A of the present example, as described above, it is possible to set the pulse width of the light pulse Peb included in one light pulse group Pe2 to 10 times or more of the pulse width of the light pulse Pea included in another light pulse group Pe1. In this case, the drive current id in which a pulse group corresponding to the light pulse group Pe1 and a pulse group corresponding to the light pulse group Pe2 are provided with the time interval Δt therebetween may be provided from the driver circuit 4 to the semiconductor laser element 2 in the current supply step ST2.

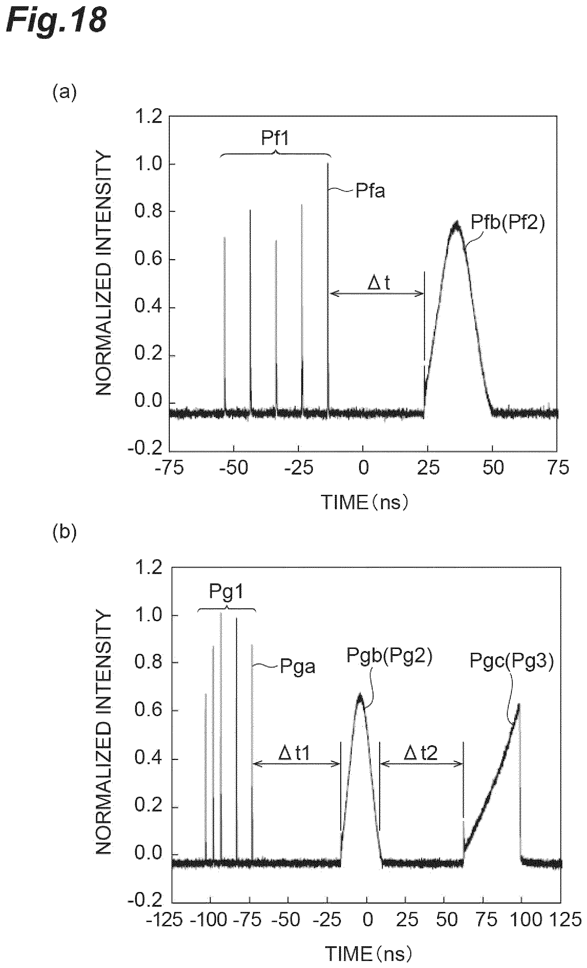

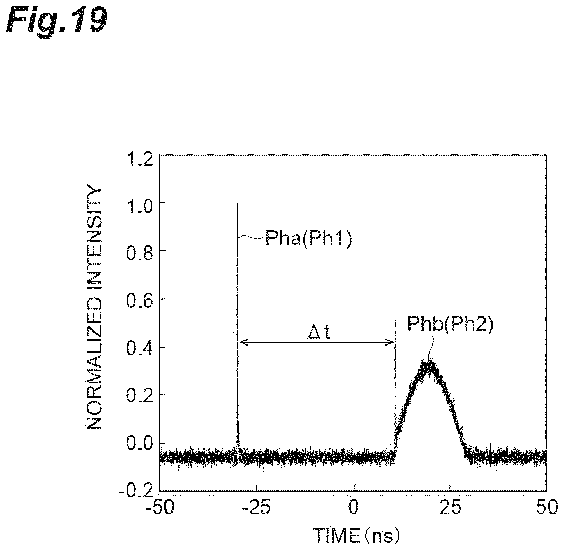

FIG. 18 and FIG. 19 include graphs (measured values) showing other examples. (a) in FIG. 18 shows a light pulse group Pf1 including a plurality of ultrashort light pulses Pfa and a light pulse group Pf2 including a single light pulse Pfb. The ultrashort light pulses Pfa and the light pulse Pfb are both Gaussian pulses, time widths (FWHM) are 62 ps and 15 ns, respectively, and a time interval of the plurality of ultrashort light pulses Pfa is 10 ns. A time interval Δt between the light pulse group Pf1 and the light pulse group Pf2 is 37.4 ns.

Further, (b) in FIG. 18 shows a light pulse group Pg1 including a plurality of ultrashort light pulses Pga, a light pulse group Pg2 including a single light pulse Pgb, and a light pulse group Pg3 including a single light pulse Pgc. The ultrashort light pulses Pga and the light pulse Pgb are both Gaussian pulses, and a time waveform of the light pulse Pgc is a triangular wave. Time widths (FWHM) of the ultrashort light pulses Pga and the light pulse Pgb are 62 ps and 15 ns, respectively, and a time width of the light pulse Pgc is 36 ns. A time interval of the plurality of ultrashort light pulses Pga is 5 nanoseconds in the first half and 10 nanoseconds in the latter half. A time interval Δt1 between the light pulse group Pg1 and the light pulse group Pg2 is 58.2 ns, and a time interval Δt2 between the light pulse group Pg2 and the light pulse group Pg3 is 49.9 ns.

Further, FIG. 19 shows a light pulse group Ph1 including a single light pulse Pha and a light pulse group Ph2 including a single light pulse Phb. The light pulses Pha and Phb are both Gaussian pulses, and time widths (FWHM) are 62 ps and 12 ns, respectively. A time interval Δt between the light pulse group Ph1 and the light pulse group Ph2 is 40.9 ns.

In addition, in each waveform shown in FIG. 18 and FIG. 19, the drive current id in which pulse groups corresponding to the light pulse groups Pf1, Pf2 (Pg1 to Pg3 or Ph1, Ph2) are provided with the time interval Δt (or Δt1, Δt2) may be provided from the driver circuit 4 to the semiconductor laser element 2 in the current supply step ST2.

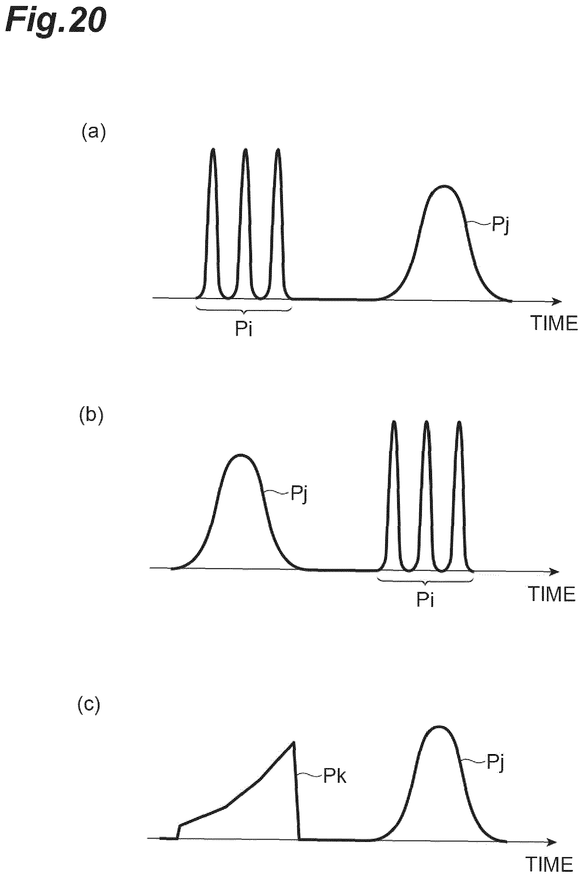

(a) to (c) in FIG. 20 to FIG. 24 include diagrams conceptually showing various time waveforms which can be output from the laser processing apparatus 1A of the present exmple. In these diagrams, the vertical axis indicates the light intensity, and the horizontal axis indicates the time. (a) and (b) in FIG. 20 show examples in which a light pulse group Pi being a light pulse train including a plurality of ultrashort light pulses and a light pulse group Pj including a single Gaussian pulse are combined. (a) in FIG. 20 shows the example in which the light pulse group Pj is applied after the light pulse group Pi, and (b) in FIG. 20 shows the example in which the light pulse group Pi is applied after the light pulse group Pj.

In addition, the number of the ultrashort light pulses included in the light pulse group Pi is arbitrary, and in the illustrated examples, the number of the ultrashort light pulses is 3. Further, peak intensities of the ultrashort light pulses included in the light pulse group Pi may be equal to each other, or at least one may be different from the others. Further, as in (a) and (b) in FIG. 20, the order of the light pulse groups may be appropriately changed in each example described below.

(c) in FIG. 20 shows an example in which a light pulse group Pk including a single light pulse having a time waveform of a triangular wave shape with a light intensity monotonically increasing and the light pulse group Pj including the single Gaussian pulse are combined.

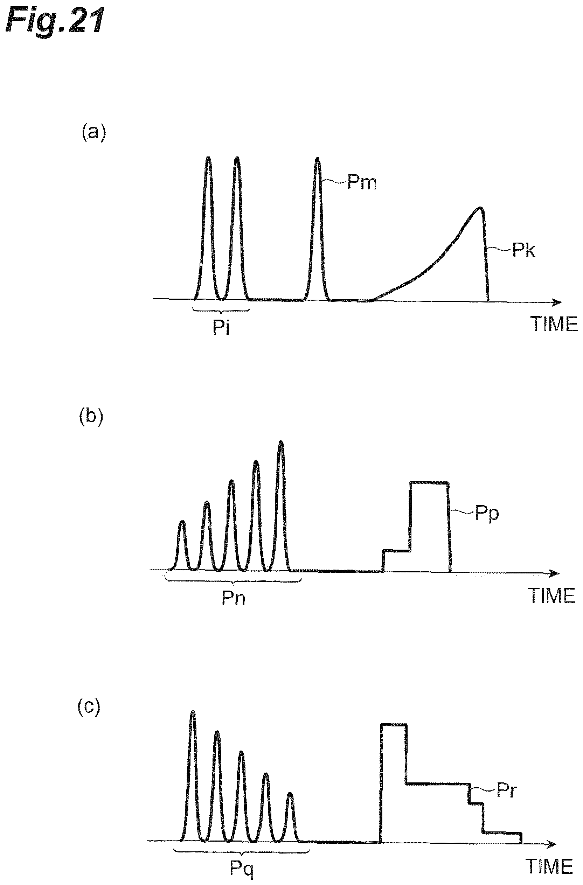

(a) in FIG. 21 shows an example in which the light pulse group Pi, a light pulse group Pm including a single ultrashort light pulse, and the light pulse group Pk are combined. In the illustrated example, the number of the ultrashort light pulses included in the light pulse group Pi is 2, and the peak intensities of the ultrashort light pulses are equal to each other.

(b) in FIG. 21 shows an example in which a light pulse group Pn being a light pulse train including a plurality of ultrashort light pulses with peak intensities of the ultrashort light pulses monotonically increasing and a light pulse group Pp including a single light pulse with a light intensity increasing in a stepwise manner are combined. The number of the ultrashort light pulses included in the light pulse group Pn is arbitrary, and in the illustrated example, the number of the ultrashort light pulses is 5. Further, the number of steps of the light pulse included in the light pulse group Pp is arbitrary, and in the illustrated example, the number of steps of the light pulse is 2.

(c) in FIG. 21 shows an example in which a light pulse group Pq being a light pulse train including a plurality of ultrashort light pulses with peak intensities of the ultrashort light pulses monotonically decreasing and a light pulse group Pr including a single light pulse with a light intensity decreasing in a stepwise manner are combined. The number of the ultrashort light pulses included in the light pulse group Pq is arbitrary, and in the illustrated example, the number of the ultrashort light pulses is 5. Further, the number of steps of the light pulse included in the light pulse group Pr is arbitrary, and in the illustrated example, the number of steps of the light pulse is 4.

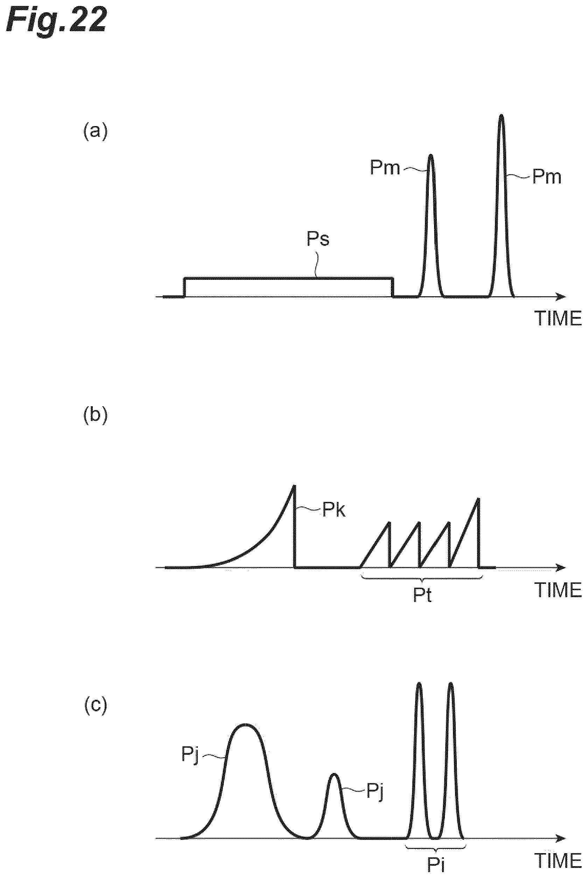

(a) in FIG. 22 shows an example in which a light pulse group Ps including a single light pulse having a time waveform including a flat section with a constant light intensity and the two light pulse groups Pm are combined.

(b) in FIG. 22 shows an example in which the light pulse group Pk and a light pulse group Pt being a light pulse train including a plurality of light pulses each having a time waveform of a triangular wave shape with light intensities monotonically increasing are combined. The number of the light pulses of the triangular wave shape included in the light pulse group Pt is arbitrary, and in the illustrated example, the number of the light pulses is 4. Further, peak intensities of the light pulses included in the light pulse group Pt may be equal to each other, or at least one may be different from the others.

(c) in FIG. 22 shows an example in which the two light pulse groups Pj having different peak intensities of the Gaussian pulses and the light pulse group Pi are combined. In the illustrated example, a peak intensity of the Gaussian pulse of the first light pulse group Pj is larger than a peak intensity of the Gaussian pulse of the second light pulse group Pj. Further, the number of the ultrashort light pulses included in the light pulse group Pi is 2, and peak intensities of the ultrashort light pulses are equal to each other.

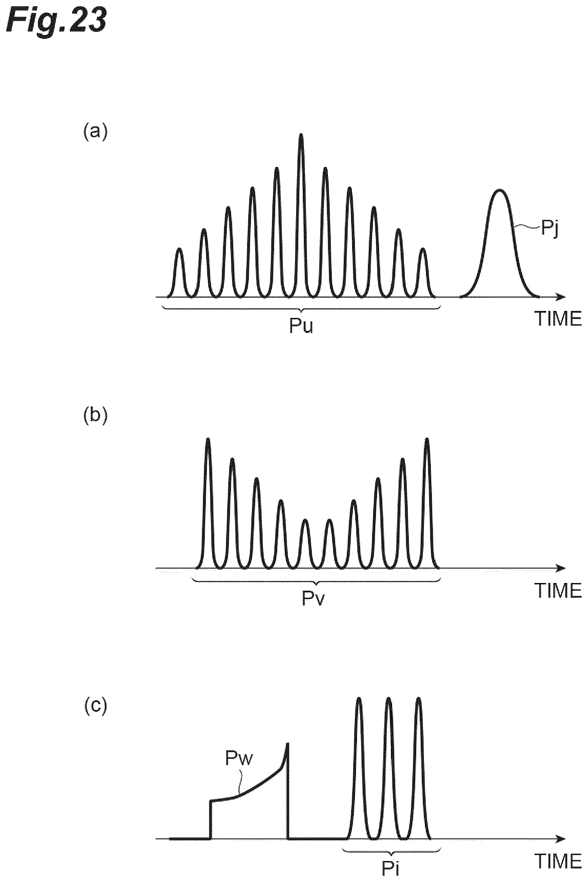

(a) in FIG. 23 shows an example in which a light pulse group Pu being a light pulse train including a plurality of ultrashort light pulses with peak intensities of the ultrashort light pulses monotonically increasing and then monotonically decreasing and the light pulse group Pj are combined. The number of the ultrashort light pulses included in the light pulse group Pu is arbitrary, and in the illustrated example, the number of the light pulses is 11.

(b) in FIG. 23 shows a light pulse group Pv being a light pulse train including a plurality of ultrashort light pulses with peak intensities of the ultrashort light pulses monotonically decreasing and then monotonically increasing. The number of the ultrashort light pulses included in the light pulse group Pv is arbitrary, and in the illustrated example, the number of the light pulses is 10.

(c) in FIG. 23 shows an example in which a light pulse group Pw including a single light pulse having a time waveform with a light intensity starting from a light intensity larger than zero and monotonically increasing and the light pulse group Pi are combined. In the illustrated example, the number of the ultrashort light pulses included in the light pulse group Pi is 3, and the peak intensities of the ultrashort light pulses are equal to each other.

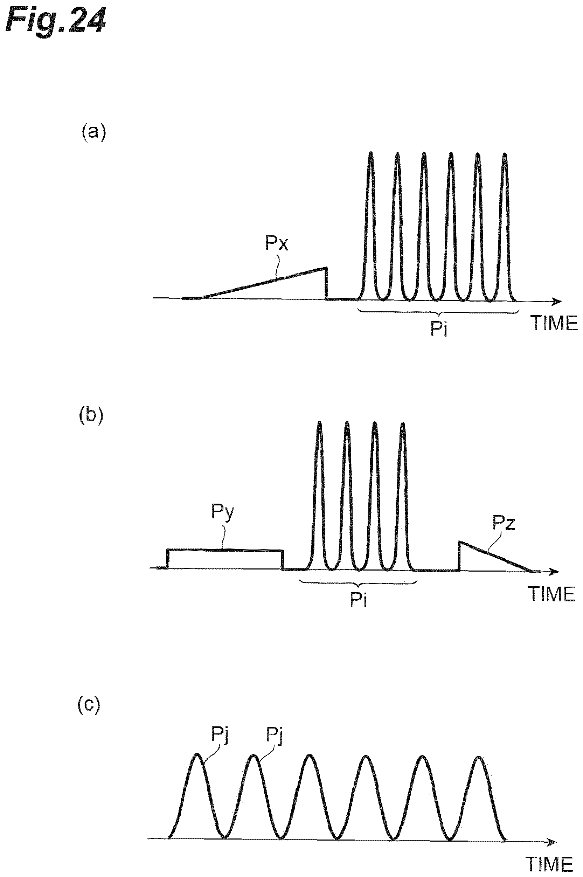

(a) in FIG. 24 shows an example in which a light pulse group Px including a single light pulse having a time waveform of a triangular wave shape with a light intensity monotonically increasing and the light pulse group Pi are combined. In the illustrated example, the number of the ultrashort light pulses included in the light pulse group Pi is 6, and the peak intensities of the ultrashort light pulses are equal to each other.

(b) in FIG. 24 shows an example in which a light pulse group Py including a single light pulse having a time waveform including a flat section with a constant light intensity, the light pulse group Pi, and a light pulse group Pz including a single light pulse having a time waveform of a triangular wave shape with a light intensity monotonically decreasing are combined. In the illustrated example, the number of the ultrashort light pulses included in the light pulse group Pi is 4, and the peak intensities of the ultrashort light pulses are equal to each other.

(c) in FIG. 24 shows an example in which a plurality of light pulse groups Pj are combined at equal intervals. The peak intensities of the Gaussian pulses of the light pulse groups Pj may be equal to each other, or at least one may be different from the others.

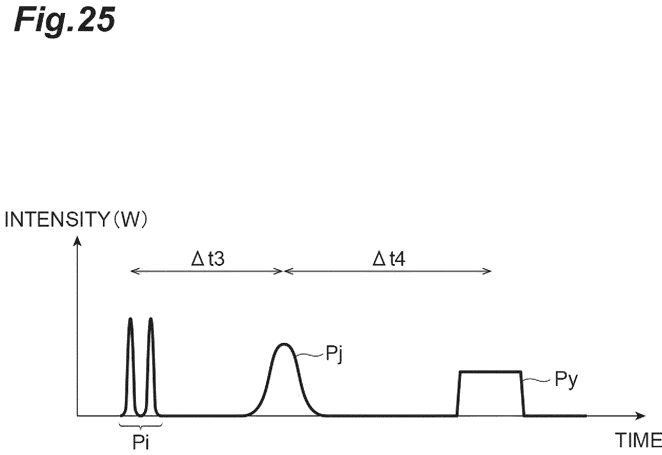

FIG. 25 is a graph showing an example in which a plurality of light pulse groups Pi, Pj, Py respectively corresponding to a plurality of processing processes are combined. In FIG. 25, the vertical axis indicates the light intensity, and the horizontal axis indicates the time. As shown in FIG. 25, the light pulse group Pi corresponding to a certain processing process is first applied, the light pulse group Pj corresponding to another processing process is applied after a time Δt3, and the light pulse group Py corresponding to still another processing process is applied after a time Δt4. In this case, these processing processes, which are conventionally performed by using separate laser processing apparatuses, can be continuously performed in a short time.

A pulse width (FWHM) of each ultrashort light pulse included in the light pulse group Pi is, for example, 1 picosecond or more and 1 nanosecond or less. A pulse width (FWHM) of the Gaussian pulse included in the light pulse group Pj is, for example, 1 nanosecond or more and 1 microsecond or less. A time width of the flat section of the light pulse included in the light pulse group Py is, for example, 1 microsecond or more and 1 millisecond or less. The time intervals Δt3 and Δt4 are, for example, 1 millisecond or less, and more preferably 200 microseconds or less.

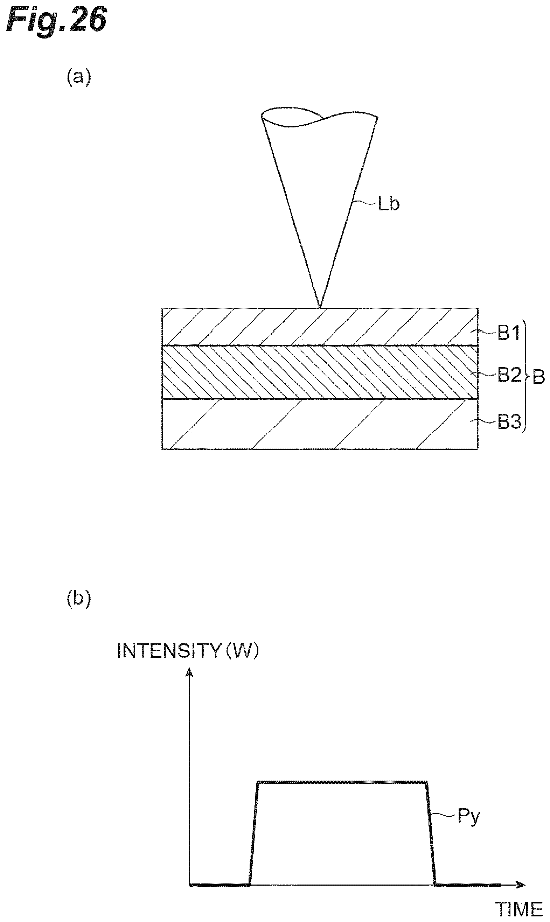

FIG. 26 to FIG. 29 show an example in which a plurality of processing processes are continuously performed in a short time by using the laser processing apparatus 1A of the present example. (a) in each of FIG. 26 to FIG. 29 shows the processing object B having a plurality of layers B1 to B3 (three layers in the diagram) with constituent materials different from each other, and the laser light Lb with which the processing object B is irradiated. (b) in each of FIG. 26 to FIG. 29 shows a time waveform of the laser light Lb in each processing process.

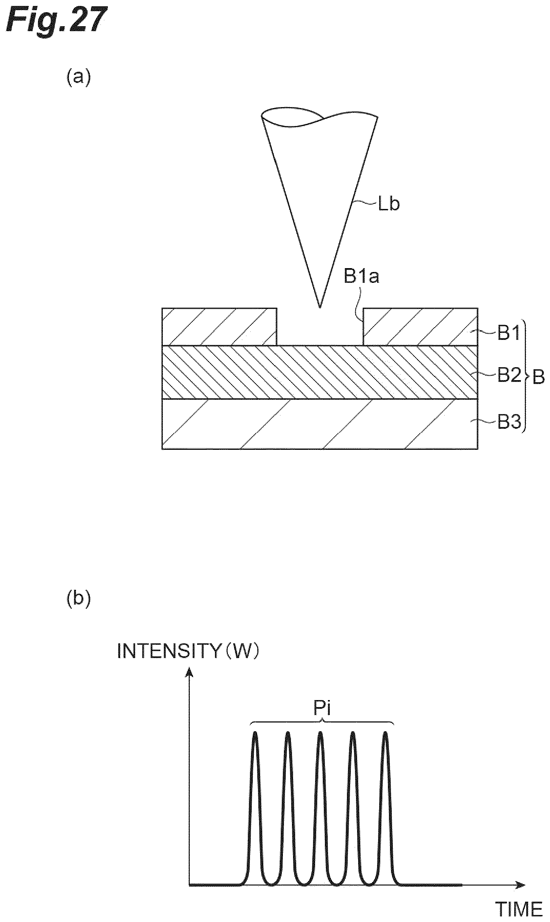

In this example, first, a processing object surface is cleaned by irradiating the uppermost layer B1 with the light pulse group Py shown in (b) in FIG. 26. In the light pulse included in the light pulse group Py, the time width of the flat section with the constant light intensity is, for example, 1 millisecond. Next, by irradiating the uppermost layer B1 with the light pulse group Pi shown in (b) in FIG. 27, a hole B1a is formed in the uppermost layer B1 as shown in (a) in FIG. 27. The time width of each light pulse included in the light pulse group Pi is, for example, 60 picoseconds.

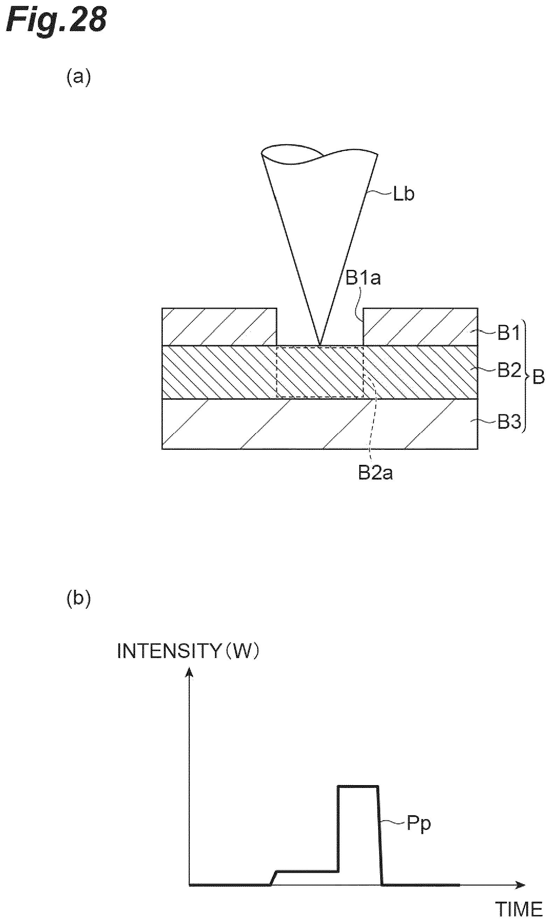

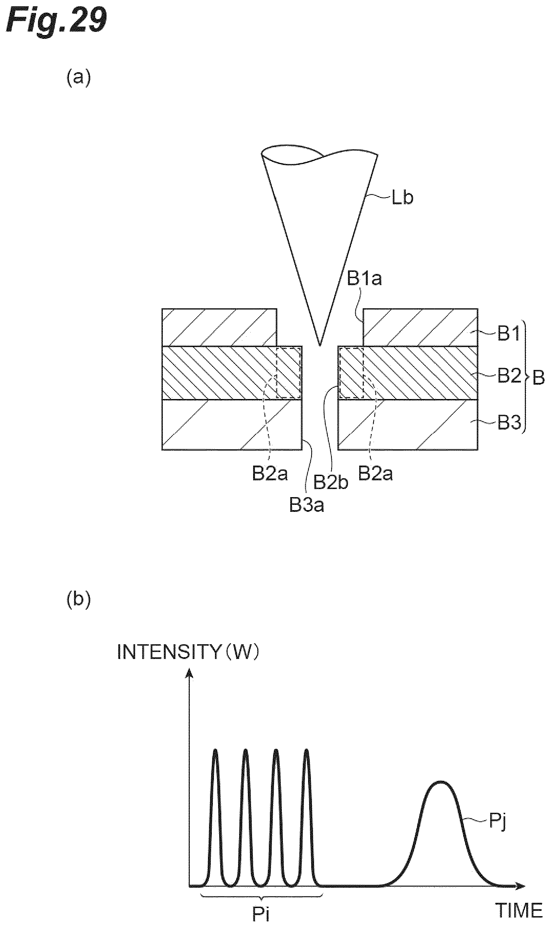

Subsequently, by irradiating the layer B2 with the light pulse group Pp shown in (b) in FIG. 28, the layer B2 is partially modified to form a modified region B2a as shown in (a) in FIG. 28. The time width of the light pulse included in the light pulse group Pp is, for example, 30 nanoseconds. Subsequently, the layer B2 is irradiated with the light pulse group Pi shown in (b) in FIG. 29, and then the layer B3 is irradiated with the light pulse group Pj, thereby forming a hole B2b in the layer B2 and a hole B3a in the layer B3, respectively, as shown in (a) in FIG. 29. The time width of each light pulse included in the light pulse group Pi is, for example, 60 picoseconds, and the FWHM of the Gaussian pulse included in the light pulse group Pj is, for example, 30 nanoseconds.

In this way, it is possible to form a through hole in a short time in the processing object B constituted by laminating different types of materials.

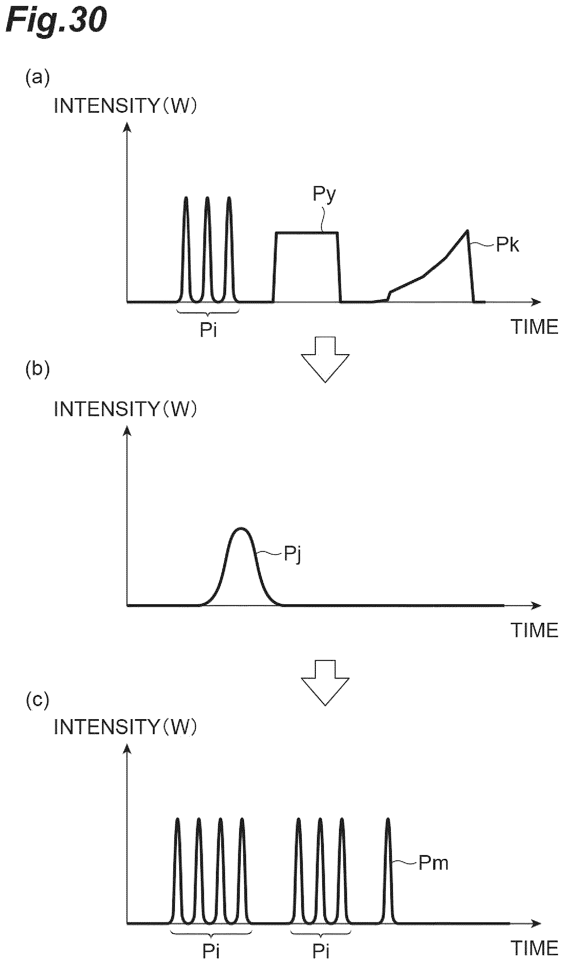

In addition, a combination of a plurality of light pulse groups corresponding to a plurality of processing processes may be as the following configuration. (a) in FIG. 30 is a graph showing a combination of the light pulse groups Pi, Py, and Pk corresponding to a certain processing process. (b) in FIG. 30 is a graph showing the light pulse group Pj corresponding to a next processing process. (c) in FIG. 30 is a graph showing the light pulse groups Pi, Pi, and Pm corresponding to a further next processing process. As in this example, a plurality of light pulse groups may be applied to the processing object B in each processing process.

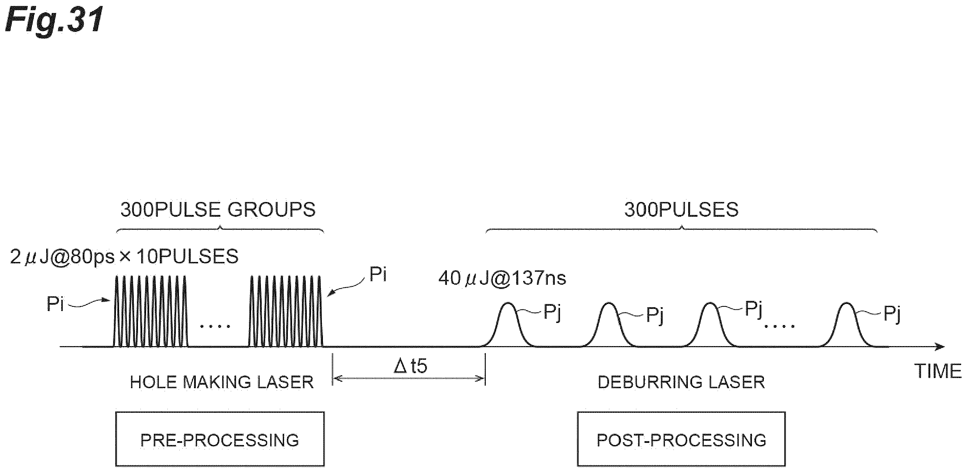

In addition, an example in which the processing object B is irradiated with a plurality of light pulse groups corresponding to a plurality of processing processes will be described. FIG. 31 is a graph showing a time waveform of the laser light Lb with which irradiation is performed in this example. As shown in FIG. 31, in this example, the laser light Lb includes a plurality of light pulse groups Pi having a time waveform suitable for hole making processing (pre-processing), and then, a plurality of light pulse groups Pj having a time waveform suitable for deburring processing (post-processing).

The number of the light pulse groups Pi was set to 300, the number of the plurality of light pulses included in the light pulse group Pi was set to 10, an energy of each light pulse was set to 2 µJ, a time width (FWDM) of each light pulse was set to 80 ps, and a time interval between the pulses was set to 2 ns. Further, the number of the light pulse groups Pj was set to 300, an energy of the Gaussian pulse of the light pulse group Pj was set to 40 µJ, and a time width (FWDM) of the Gaussian pulse was set to 137 ns. Further, a time interval Δt5 between the light pulse groups Pi and the light pulse groups Pj was set to 1 s as a time with which the processing object B becomes a steady state after the processing of the light pulse groups Pi, a time interval between the light pulse groups Pi was set to 3.3 ms, and a time interval between the light pulse groups Pj was set to 3.3 ms.

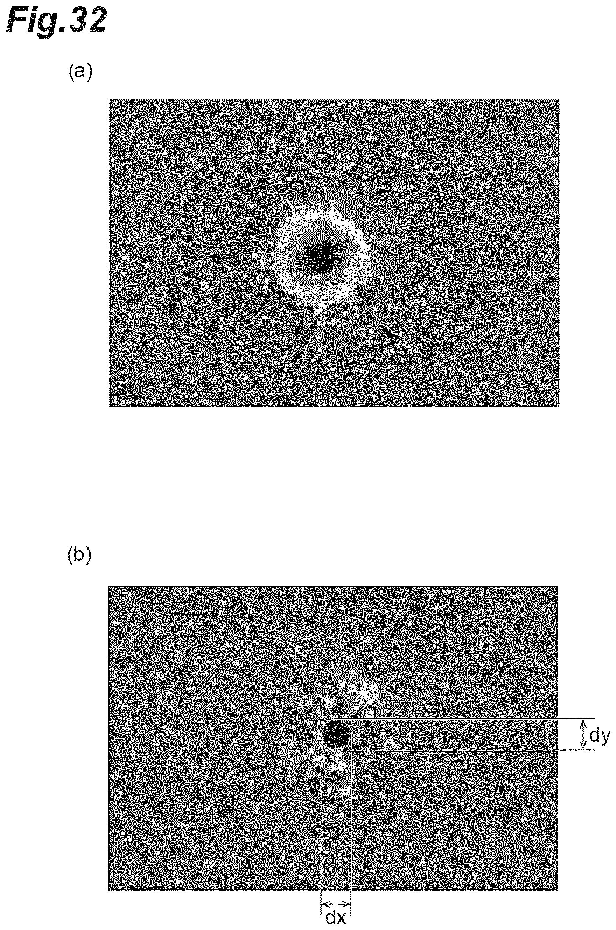

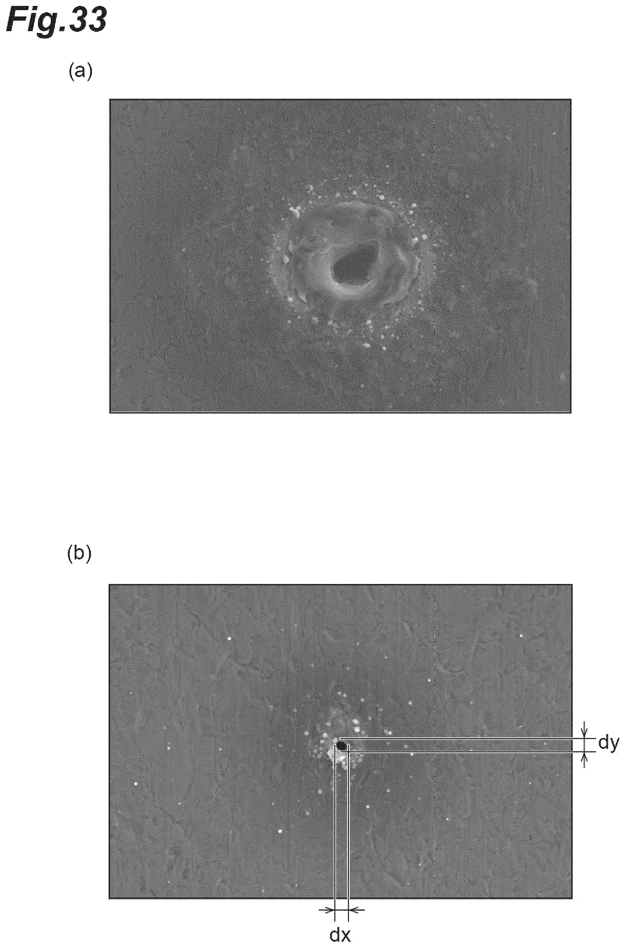

FIG. 32 and FIG. 33 include diagrams showing SEM images of a hole formed in the processing object B. FIG. 32 shows (a) the front surface (laser irradiation surface) and (b) the back surface of the processing object B after the irradiation of the light pulse groups Pi and before the irradiation of the light pulse groups Pj. Further, FIG. 33 shows (a) the front surface and (b) the back surface of the processing object B after the irradiation of the light pulse groups Pj.

When (a) in FIG. 33 is compared with (a) in FIG. 32, it can be seen that burrs around the hole generated after the irradiation of the light pulse groups Pi are melted and smoothed by the irradiation of the light pulse groups Pj. Further, when (b) in FIG. 33 is compared with (b) in FIG. 32, it can be seen that the hole diameter on the side opposite to the laser irradiation surface is reduced by melting due to the irradiation of the light pulse groups Pj.

In addition, when the hole diameter on the back surface of the processing object B was measured, the width dx in the horizontal direction of the paper plane was 8.3 µm, the width dy in the vertical direction of the paper plane was 8.1 µm, and the average width was 8.2 µm before the irradiation of the light pulse groups Pj ((b) in FIG. 32), whereas the width dx in the horizontal direction of the paper plane was 2.9 µm, the width dy in the vertical direction of the paper plane was 2.7 µm, and the average width was 2.8 µm after the irradiation of the light pulse groups Pj ((b) in FIG. 33).

Effects obtained by the laser processing apparatus 1A and the laser processing method of the present example described above will be described.

In the laser processing apparatus 1A and the laser processing method of the present example, the waveform output unit 6 outputs the input waveform data Da, and the driver circuit 4 supplies the drive current id having the time waveform according to the input waveform data Da to the semiconductor laser element 2. Therefore, by including an arbitrary time waveform in the input waveform data Da, a light pulse having an arbitrary time waveform can be output from the semiconductor laser element 2. Further, by including a plurality of pulse groups having a time difference in the input waveform data Da, a plurality of light pulse groups having a time difference can be output from the semiconductor laser element 2.

That is, according to the present example, it is possible to irradiate the processing object B with the plurality of light pulse groups having different time waveforms with the time difference therebetween. In addition, since the plurality of light pulse groups are output from the single semiconductor laser element 2 on the single optical path, the apparatus configuration can be reduced in size as compared with the methods described in Patent Documents 1 and 2.

Further, by irradiating the processing object B with the plurality of light pulse groups having different time waveforms in a short period of time (continuously), the plurality of light pulse groups act on the processing object B in a combined manner, and various processing shapes and processing qualities, which have been considered difficult conventionally, such as formation of the depressed portion having the diameter smaller than the irradiation diameter as illustrated in (b) in FIG. 16, can be realized.

Further, as in the conventional technique, when a light source having an appropriate time waveform is prepared for each processing process and each processing process is performed, an operation for replacing the light source is necessary, and an operation for correcting a deviation of an optical axis after replacing the light source is further necessary, and thus, a time required for processing processes becomes long. On the other hand, according to the present example, as illustrated in FIG. 26 to FIG. 29 and FIG. 31 to FIG. 33, a plurality of light pulse groups each having a time waveform suitable for each of a plurality of processing processes can be generated from the single semiconductor laser element 2 in a short period of time (continuously), and a time required for processing processes can be significantly reduced.

As in the present example, the driver circuit 4 (current supply step ST2) may include the D/A conversion unit 46 (D/A conversion step ST21) for converting the digital input waveform data Da into the analog drive signal Sd, and the current conversion unit 45 (current conversion step ST22) for converting the drive signal Sd into the drive current id. Further, the D/A conversion unit 46 (D/A conversion step ST21) may sequentially convert the plurality of continuous section waveform data DD1 to DD4 obtained by dividing the time waveform of the input waveform data Da into the drive signal Sd while providing the time difference. In this case, it is possible to further increase a speed of the drive signal Sd and improve a time resolution of the time waveform of the light pulse.

As in the present example, the time width of each of the one or plurality of pulses in each light pulse group may be 1 microsecond or less. By irradiating the processing object B with the light pulse having the short time width as described above, it is possible to increase a light intensity of the laser light Lb while controlling thermal influence on the periphery of the processing region, and it is possible to improve processing accuracy.

As in the present example, the time interval between the light pulse groups may be 200 microseconds or less. In this case, it is possible to irradiate the processing object B with the laser light Lb including the two or more light pulse groups in a short time, and a time required for processing can be reduced.

As in the present example, the waveform output unit 6 (in the current supply step ST2) may change the time waveform of at least one pulse group out of the two or more light pulse groups in the laser light Lb during processing of the processing object B. In the present embodiment, as described above, it is possible to easily change the time waveform of the pulse group during processing of the processing object B. Therefore, it is possible to continuously perform processing processes of a plurality of stages in which time waveforms required for the laser light are different from each other in a short time, and a time required for processing can be reduced.

As in the present example, the pulse width of the one or plurality of light pulses in one light pulse group may be 10 times or more of the pulse width of the one or plurality of light pulses in another light pulse group. According to the present embodiment, for example, it is possible to continuously output the light pulses having greatly different pulse widths in a short time, and to adapt to various processing conditions.

Embodiment of the invention

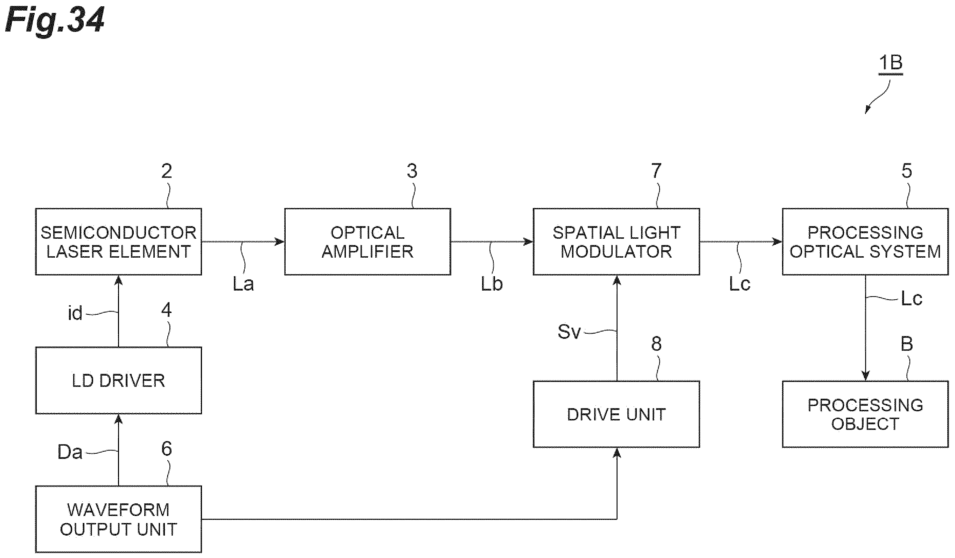

FIG. 34 is a block diagram illustrating a configuration of the above example modified in accordance with the invention. As illustrated in FIG. 34, a laser processing apparatus 1B of the present embodiment of the invention further includes a spatial light modulator 7 and a drive unit 8 in addition to the configuration of the laser processing apparatus 1A of the above embodiment.

The spatial light modulator 7 includes a plurality of pixels arranged two-dimensionally, and individually modulates a phase of incident light in each pixel. The spatial light modulator 7 may be a transmission type or a reflection type. In one example, the spatial light modulator 7 is a liquid crystal on silicon - spatial light modulator (LCOS-SLM) of a liquid crystal type.

The spatial light modulator 7 is disposed on an optical path between the semiconductor laser element 2 and the processing optical system 5 (in the illustrated example, on an optical path between the optical amplifier 3 and the processing optical system 5). The spatial light modulator 7 spatially modulates the phase of the laser light Lb output from the optical amplifier 3, and outputs the laser light Lc after the modulation to the processing optical system 5. The laser light Lc is applied to the processing object B via the processing optical system 5. That is, in the light irradiation step ST6 illustrated in FIG. 6, the processing object B is irradiated with the laser light Lb via the spatial light modulator 7.

The drive unit 8 is a circuit for applying a voltage signal Sv for driving the spatial light modulator 7 to each pixel of the spatial light modulator 7. The magnitude of the voltage signal Sv for each pixel is determined based on a computer generated hologram (CGH) generated in the waveform output unit 6.

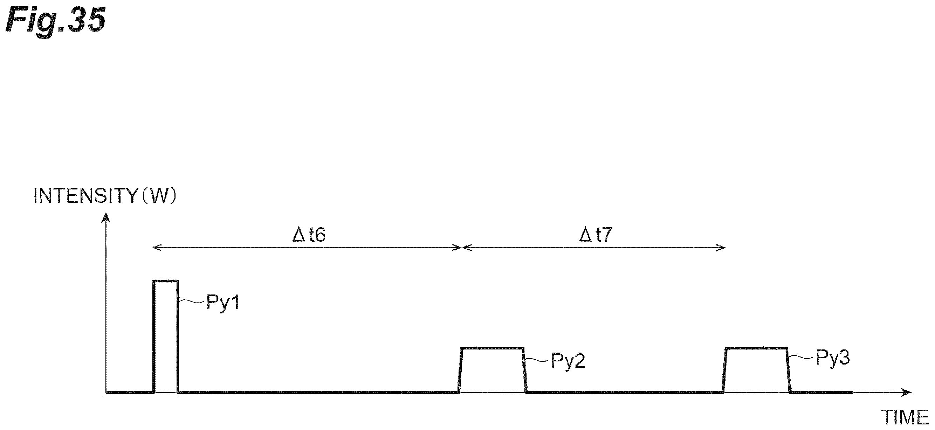

FIG. 35 shows an example of a plurality of light pulse groups with which the processing object B is irradiated in the present modification. For example, the processing object B is irradiated with a light pulse group Py1, the processing object B is irradiated with a light pulse group Py2 after a time Δt6, and the processing object B is further irradiated with a light pulse group Py3 after a time Δt7. The above irradiation configuration is realized by including pulse groups corresponding to the light pulse groups Py1, Py2, and Py3 in the drive current id from the driver circuit 4.

In addition, in the present modification, the spatial light modulator 7 presents a CGH for making positions on the processing object B to which the light pulse groups Py1, Py2, Py3 are applied different for the respective light pulse groups Py1, Py2, Py3, or making an irradiation position of at least one light pulse group Py1, Py2, or Py3 different from an irradiation position of the other light pulse groups. In other words, the spatial light modulator 7 sequentially presents the CGH for irradiating the first irradiation position with the first light pulse group Py1 (or Py2) and the CGH for irradiating the second irradiation position different from the first irradiation position with the second light pulse group Py2 (or Py3). In addition, the times Δt6 and Δt7 described above are longer than a time required for the spatial light modulator 7 to change the CGH.

According to the present modification, at least two processing portions can be irradiated with the light pulse groups having different time waveforms, and the irradiation of these light pulse groups can be continuously performed in a short time. Therefore, a time required for processing can be remarkably reduced as compared with the conventional laser processing apparatus.

The laser processing apparatus and the laser processing method are not limited to the embodiments and configuration examples described above, and may be modified in various ways. For example, the target waveform data is stored in the waveform output unit 6 in the above embodiment, and further, the target waveform data may be input from the outside of the laser processing apparatus 1A. Further, the optical amplifier 3 and/or the optical isolator 12 may be omitted as appropriate.

Further, in the above embodiment, the waveform output unit 6 includes the waveform adjustment unit 32 and the comparison unit 33, and generates the input waveform data Da by performing feedback of the time waveform of the laser light Lb, and further, the configuration for the feedback may not be provided, and the target waveform data Db from the computer 31 may be used as it is to generate the laser light Lb.

The laser processing apparatus of the above embodiment includes a semiconductor laser element; a waveform output unit for outputting input waveform data; a driver circuit for generating a drive current having a time waveform according to the input waveform data and supplying the drive current to the semiconductor laser element; and an optical system for irradiating a processing object with laser light output from the semiconductor laser element, and the semiconductor laser element outputs the laser light in which two or more light pulse groups each including one or a plurality of light pulses are provided with a time interval therebetween, time waveforms of at least two light pulse groups out of the two or more light pulse groups are different from each other, and the time waveform includes at least one of a time waveform of each of the one or plurality of light pulses, a time width of each of the one or plurality of light pulses, and a time interval of the plurality of light pulses.

The laser processing method of the above embodiment includes a current supply step of generating a drive current having a time waveform according to input waveform data and supplying the drive current to a semiconductor laser element; and a light irradiation step of irradiating a processing object with laser light output from the semiconductor laser element, and in the light irradiation step, the semiconductor laser element outputs the laser light in which two or more light pulse groups each including one or a plurality of light pulses are provided with a time interval therebetween, time waveforms of at least two light pulse groups out of the two or more light pulse groups are different from each other, and the time waveform includes at least one of a time waveform of each of the one or plurality of light pulses, a time width of each of the one or plurality of light pulses, and a time interval of the plurality of light pulses.

In the above laser processing apparatus, the driver circuit may include a D/A conversion unit for converting the digital input waveform data into an analog drive signal; and a current conversion unit for converting the drive signal into the drive current, and the D/A conversion unit may sequentially convert a plurality of continuous section waveform data obtained by dividing the time waveform of the input waveform data into the drive signal while providing a time difference.

In the above laser processing method, the current supply step may include a D/A conversion step of converting the digital input waveform data into an analog drive signal; and a current conversion step of converting the drive signal into the drive current, and in the D/A conversion step, a plurality of continuous section waveform data obtained by dividing the time waveform of the input waveform data may be sequentially converted into the drive signal while providing a time difference.

According to the above apparatus and the method, it is possible to further increase a speed of the drive signal and improve a time resolution of the time waveform of the light pulse.

In the above laser processing apparatus and the laser processing method, the time width of each of the one or plurality of light pulses in each light pulse group may be 1 microsecond or less. By irradiating the processing object with the light pulse having the short time width as described above, it is possible to increase a light intensity of the laser light while controlling thermal influence on the periphery of the processing region, and it is possible to improve processing accuracy.

In the above laser processing apparatus and the laser processing method, the time interval between the two or more light pulse groups may be 200 microseconds or less. In this case, it is possible to irradiate the processing object with the two or more light pulse groups in a short time, and a time required for processing can be reduced.

In the above laser processing apparatus, the waveform output unit may change the time waveform of at least one light pulse group out of the two or more light pulse groups during processing of the processing object. Further, in the above laser processing method, the time waveform of at least one light pulse group out of the two or more light pulse groups may be changed during processing of the processing object.

In the above apparatus and the method, as described above, it is possible to easily change the time waveform of the light pulse group during processing of the processing object. Therefore, it is possible to continuously perform processing of a plurality of stages in which time waveforms required for the laser light are different from each other in a short time, and a time required for processing can be reduced.

In the above laser processing apparatus and the laser processing method, a pulse width of the one or plurality of light pulses in one light pulse group out of the at least two light pulse groups may be 10 times or more of a pulse width of the one or plurality of light pulses in another light pulse group. According to the above apparatus and the method, for example, it is possible to continuously output the light pulses having greatly different pulse widths in a short time, and to adapt to various processing conditions.

### Industrial Applicability

The present invention can be used as a laser processing apparatus and a laser processing method capable of reducing a size of a configuration in which a processing object is irradiated with a plurality of light pulses having different time waveforms.

### Reference Signs List

1A, 1B - laser processing apparatus, 2 - semiconductor laser element, 3 - optical amplifier, 4 - driver circuit, 5 - processing optical system, 6 - waveform output unit, 7 - spatial light modulator, 8 - drive unit, 11 - bias current control unit, 12, 21, 23, 27, 29 - optical isolator, 13 - optical branch unit, 14 - photodetection unit, 15 - light waveform detection unit, 22 - optical fiber amplifier, 24 - bandpass filter, 25 - optical fiber connector, 26 - collimator lens, 28, 30 - solid-state laser amplifier, 31 - computer, 32 - waveform adjustment unit, 33 - comparison unit, 41 - control board, 41a - CPU, 41b - high-speed DAC interface, 42 - waveform data storage unit, 43 - waveform timing adjustment unit, 44 - waveform signal generation unit, 45 - current conversion unit, 46 - D/A conversion unit, B - processing object, B1 - B3 - layer, B1a, B2b, B3a - hole, B2a - modified region, Da - input waveform data, Db - target waveform data, Dc - difference data, DD1 - DD4 - section waveform data, F1 - F3 - optical fiber, id - drive current, La, Lb, Lc - laser light, Pa - light pulse (Gaussian pulse), Pb, Pc, Pe1, Pe2, Pf1, Pf2, Pg1, Pg2, Pg3, Ph1, Ph2, Pi - Pz, Py1, Py2, Py3 - light pulse group, Pba, Pca, Pfa, Pga - ultrashort light pulse, Pd, Pea, Peb, Pfb, Pgb, Pgc, Pha, Phb - light pulse, Sc - light intensity signal, Sd - drive signal, Sv - voltage signal, TA - delay time, Δt, Δt1, Δt2, Δt5 - time interval.

## Claims

1. A laser processing apparatus comprising:
a semiconductor laser element (2);
a waveform output unit (6) for outputting input waveform data (Da);
a driver circuit (4) for generating a drive current (id) having a time waveform according to the input waveform data (Da) and supplying the drive current (id) to the semiconductor laser element (2);
an optical system (5) for irradiating a processing object (B) with laser light (La) output from the semiconductor laser element (2); wherein
the semiconductor laser element (2) outputs the laser light (La) in which two or more light pulse groups each including one or a plurality of light pulses are provided with a time interval (Δt) therebetween,
time waveforms of at least two light pulse groups out of the two or more light pulse groups are different from each other,
the time waveform includes at least one of a time waveform of each of the one or plurality of light pulses, a time width of each of the one or plurality of light pulses, and a time interval of the plurality of light pulses, and **characterized by** a spatial light modulator (7) disposed on an optical path between the semiconductor laser element (2) and the optical system (5), wherein
the spatial light modulator (7) sequentially presents a hologram for irradiating a first irradiation position with the laser light corresponding to a first light pulse group included in the two or more light pulse groups and a hologram for irradiating a second irradiation position different from the first irradiation position with the laser light corresponding to a second light pulse group.

2. The laser processing apparatus according to Claim 1, wherein the driver circuit (4) includes:
a D/A conversion unit (46) for converting the digital input waveform data into an analog drive signal; and
a current conversion unit (45) for converting the drive signal into the drive current (id), wherein
the D/A conversion unit (46) sequentially converts a plurality of continuous section waveform data obtained by dividing the time waveform of the input waveform data (Da) into the drive signal while providing a time difference.

3. The laser processing apparatus according to Claim 1 or 2, wherein the time width of each of the one or plurality of light pulses in each light pulse group is 1 microsecond or less.

4. The laser processing apparatus according to any one of Claims 1 to 3, wherein the time interval between the two or more light pulse groups is 200 microseconds or less.

5. The laser processing apparatus according to any one of Claims 1 to 4, wherein the waveform output unit (6) changes the time waveform of at least one light pulse group out of the two or more light pulse groups during processing of the processing object (B).

6. The laser processing apparatus according to any one of Claims 1 to 5, wherein a pulse width of the one or plurality of light pulses in one light pulse group out of the at least two light pulse groups is 10 times or more of a pulse width of the one or plurality of light pulses in another light pulse group.

7. A laser processing method comprising:
a current supply step of generating a drive current having a time waveform according to input waveform data and supplying the drive current to a semiconductor laser element (2); and
a light irradiation step of irradiating a processing object (B) with laser light output from the semiconductor laser element (2), wherein
in the light irradiation step, the semiconductor laser element (2) outputs the laser light in which two or more light pulse groups each including one or a plurality of light pulses are provided with a time interval therebetween,
time waveforms of at least two light pulse groups out of the two or more light pulse groups are different from each other,
the time waveform includes at least one of a time waveform of each of the one or plurality of light pulses, a time width of each of the one or plurality of light pulses, and a time interval of the plurality of light pulses, and **characterized in that**,
in the light irradiation step, the processing object (B) is irradiated with the laser light via a spatial light modulator (7), and **in that** a hologram for irradiating a first irradiation position with the laser light corresponding to a first light pulse group included in the two or more light pulse groups and a hologram for irradiating a second irradiation position different from the first irradiation position with the laser light corresponding to a second light pulse group are sequentially presented on the spatial light modulator (7).

8. The laser processing method according to Claim 7, wherein the current supply step includes:
a D/A conversion step of converting the digital input waveform data into an analog drive signal; and
a current conversion step of converting the drive signal into the drive current (id), wherein
in the D/A conversion step, a plurality of continuous section waveform data obtained by dividing the time waveform of the input waveform data (Da) are sequentially converted into the drive signal while providing a time difference.

9. The laser processing method according to Claim 7 or 8, wherein the time width of each of the one or plurality of light pulses in each light pulse group is 1 microsecond or less.

10. The laser processing method according to any one of Claims 7 to 9, wherein the time interval between the two or more light pulse groups is 200 microseconds or less.

11. The laser processing method according to any one of Claims 7 to 10, wherein the time waveform of at least one light pulse group out of the two or more light pulse groups is changed during processing of the processing object (B).

12. The laser processing method according to any one of Claims 7 to 11, wherein a pulse width of the one or plurality of light pulses in one light pulse group out of the at least two light pulse groups is 10 times or more of a pulse width of the one or plurality of light pulses in another light pulse group.

## Patentansprüche

1. Eine Laserbearbeitungsvorrichtung aufweisend:
ein Halbleiterlaserelement (2);
eine Wellenformausgabeeinheit (6) zum Ausgeben von Eingangswellenformdaten (Da);
eine Treiberschaltung (4) zum Erzeugen eines Treiberstroms (id) mit einer Zeitwellenform gemäß den Eingangswellenformdaten (Da) und zum Zuführen des Treiberstroms (id) zu dem Halbleiterlaserelement (2);
ein optisches System (5) zum Bestrahlen eines zu bearbeitenden Objekts (B) mit Laserlicht (La), das von dem Halbleiterlaserelement (2) ausgegeben wird;
wobei
das Halbleiterlaserelement (2) das Laserlicht (La) ausgibt, in dem zwei oder mehr Lichtimpulsgruppen, die jeweils einen oder eine Vielzahl von Lichtimpulsen enthalten, mit einem Zeitintervall (Δt) dazwischen vorgesehen sind,
die Zeitwellenformen von mindestens zwei Lichtimpulsgruppen aus den zwei oder mehr Lichtimpulsgruppen voneinander verschieden sind,
die Zeitwellenform mindestens eine Zeitwellenform jedes der einen oder mehreren Lichtimpulse, eine Zeitbreite jedes der einen oder mehreren Lichtimpulse und ein Zeitintervall der Vielzahl von Lichtimpulsen umfasst, und **gekennzeichnet durch** einen räumlichen Lichtmodulator (7), der auf einem optischen Pfad zwischen dem Halbleiterlaserelement (2) und dem optischen System (5) angeordnet ist, wobei
der räumliche Lichtmodulator (7) sequentiell ein Hologramm zum Bestrahlen einer ersten Bestrahlungsposition mit dem Laserlicht entsprechend einer ersten Lichtimpulsgruppe, die in den zwei oder mehr Lichtimpulsgruppen enthalten ist, und ein Hologramm zum Bestrahlen einer zweiten Bestrahlungsposition, die sich von der ersten Bestrahlungsposition unterscheidet, mit dem Laserlicht entsprechend einer zweiten Lichtimpulsgruppe darstellt.

2. Die Laserbearbeitungsvorrichtung nach Anspruch 1, wobei die Treiberschaltung (4) umfasst:
eine D/A-Wandlereinheit (46) zum Umwandeln der digitalen Eingangswellenformdaten in ein analoges Treibersignal; und
eine Stromumwandlungseinheit (45) zum Umwandeln des Treibersignals in den Treiberstrom (id), wobei
die D/A-Wandlereinheit (46) sequentiell eine Vielzahl von kontinuierlichen Abschnitt-Wellenformdaten, die durch Teilen der Zeitwellenform der Eingangswellenformdaten (Da) erhalten werden, in das Treibersignal umwandelt, während eine Zeitdifferenz bereitgestellt wird.

3. Die Laserbearbeitungsvorrichtung nach Anspruch 1 oder 2, wobei die zeitliche Breite jedes der einen oder einer Vielzahl von Lichtimpulsen in jeder Lichtimpulsgruppe 1 Mikrosekunde oder weniger beträgt.

4. Die Laserbearbeitungsvorrichtung nach einem der Ansprüche 1 bis 3, wobei der zeitliche Abstand zwischen den zwei oder mehr Lichtpulsgruppen 200 Mikrosekunden oder weniger beträgt.

5. Die Laserbearbeitungsvorrichtung nach einem der Ansprüche 1 bis 4, wobei die WellenformAusgabeeinheit (6) die zeitliche Wellenform von mindestens einer Lichtpulsgruppe aus den zwei oder mehr Lichtpulsgruppen während der Bearbeitung des Objekts (B) ändert.

6. Die Laserbearbeitungsvorrichtung nach einem der Ansprüche 1 bis 5, wobei die Impulsbreite des einen oder der Vielzahl von Lichtimpulsen in einer Lichtimpulsgruppe aus den mindestens zwei Lichtimpulsgruppen das Zehnfache oder mehr der Impulsbreite des einen oder der Vielzahl von Lichtimpulsen in einer anderen Lichtimpulsgruppe beträgt.

7. Ein Laserbearbeitungsverfahren, das Folgendes aufweist:
einen Stromversorgungsschritt des Erzeugens eines Treiberstroms mit einer Zeitwellenform gemäß Eingangswellenformdaten und des Zuführens des Treiberstroms zu einem Halbleiterlaserelement (2); und
einen Lichtbestrahlungsschritt des Bestrahlens eines Objekts (B) mit Laserlicht, das von dem Halbleiterlaserelement (2) ausgegeben wird, wobei
in dem Lichtbestrahlungsschritt das Halbleiterlaserelement (2) das Laserlicht ausgibt, in dem zwei oder mehr Lichtimpulsgruppen, die jeweils einen oder eine Vielzahl von Lichtimpulsen enthalten, mit einem Zeitintervall dazwischen bereitgestellt werden,
die Zeitwellenformen von mindestens zwei Lichtpulsgruppen aus den zwei oder mehr Lichtpulsgruppen voneinander verschieden sind,
die Zeitwellenform mindestens eine Zeitwellenform jedes der einen oder mehreren Lichtimpulse, eine Zeitbreite jedes der einen oder mehreren Lichtimpulse und ein Zeitintervall der Vielzahl von Lichtimpulsen umfasst, und **dadurch gekennzeichnet, dass**
in dem Lichtbestrahlungsschritt das zu bearbeitende Objekt (B) mit dem Laserlicht über einen räumlichen Lichtmodulator (7) bestrahlt wird, und dass ein Hologramm zum Bestrahlen einer ersten Bestrahlungsposition mit dem Laserlicht, das einer ersten Lichtimpulsgruppe entspricht, die in den zwei oder mehr Lichtimpulsgruppen enthalten ist, und ein Hologramm zum Bestrahlen einer zweiten Bestrahlungsposition, die sich von der ersten Bestrahlungsposition unterscheidet, mit dem Laserlicht, das einer zweiten Lichtimpulsgruppe entspricht, nacheinander auf dem räumlichen Lichtmodulator (7) dargestellt werden.

8. Das Laserbearbeitungsverfahren nach Anspruch 7, wobei der Stromversorgungsschritt umfasst:
einen D/A-Wandlungsschritt zum Umwandeln der digitalen Eingangswellenformdaten in ein analoges Treibersignal; und
einen Stromumwandlungsschritt zum Umwandeln des Treibersignals in den Treiberstrom (id), wobei
in dem D/A-Wandlungsschritt eine Vielzahl von kontinuierlichen Abschnitts-Wellenformdaten, die durch Teilen der Zeitwellenform der Eingangswellenformdaten (Da) erhalten werden, sequentiell in das Treibersignal umgewandelt werden, während eine Zeitdifferenz bereitgestellt wird.

9. Das Laserbearbeitungsverfahren nach Anspruch 7 oder 8, wobei die zeitliche Breite jedes der einen oder einer Vielzahl von Lichtimpulsen in jeder Lichtimpulsgruppe 1 Mikrosekunde oder weniger beträgt.

10. Das Laserbearbeitungsverfahren nach einem der Ansprüche 7 bis 9, wobei der zeitliche Abstand zwischen den zwei oder mehr Lichtpulsgruppen 200 Mikrosekunden oder weniger beträgt.

11. Das Laserbearbeitungsverfahren nach einem der Ansprüche 7 bis 10, wobei die zeitliche Wellenform mindestens einer Lichtpulsgruppe aus den zwei oder mehr Lichtpulsgruppen während der Bearbeitung des Objekts (B) geändert wird.

12. Das Laserbearbeitungsverfahren nach einem der Ansprüche 7 bis 11, wobei die Impulsbreite des einen oder der Vielzahl von Lichtimpulsen in einer Lichtimpulsgruppe aus den mindestens zwei Lichtimpulsgruppen das Zehnfache oder mehr der Impulsbreite des einen oder der Vielzahl von Lichtimpulsen in einer anderen Lichtimpulsgruppe beträgt.

## Revendications

1. Appareil de traitement au laser comprenant :
un élément laser à semi-conducteur (2) ;
une unité de sortie de forme d'onde (6) pour délivrer en sortie des données de forme d'onde d'entrée (Da) ;
un circuit d'attaque (4) pour générer un courant d'attaque (id) ayant une forme d'onde temporelle conformément aux données de forme d'onde d'entrée (Da) et appliquer le courant d'attaque (id) à l'élément laser à semi-conducteur (2) ;
un système optique (5) pour irradier un objet à traiter (B) avec une lumière laser (La) délivrée en sortie par l'élément laser à semi-conducteur (2) ;
dans lequel l'élément laser à semi-conducteur (2) délivre en sortie la lumière laser (La) dans laquelle deux groupes de pulsations lumineuses ou plus comportant chacun une ou une pluralité de pulsations lumineuses sont fournis avec un intervalle de temps (Δt) entre eux,
les formes d'onde temporelles d'au moins deux groupes de pulsations lumineuses parmi les deux groupes de pulsations lumineuses ou plus sont différentes les unes des autres,
la forme d'onde temporelle comporte au moins l'un parmi une forme d'onde temporelle de chacune des une ou une pluralité de pulsations lumineuses, une largeur de temps de chacune des une ou une pluralité de pulsations lumineuses, et un intervalle de temps de la pluralité de pulsations lumineuses, et **caractérisé par** un modulateur spatial de lumière (7) disposé sur un chemin optique entre l'élément laser à semi-conducteur (2) et le système optique (5), dans lequel
le modulateur spatial de lumière (7) présente séquentiellement un hologramme pour irradier une première position d'irradiation avec la lumière laser correspondant à un premier groupe de pulsations lumineuses compris dans les deux groupes de pulsations lumineuses ou plus et un hologramme pour irradier une seconde position d'irradiation différente de la première position d'irradiation avec la lumière laser correspondant à un second groupe de pulsations lumineuses.

2. Appareil de traitement au laser selon la revendication 1, dans lequel le circuit d'attaque (4) comporte :
une unité de conversion N/A (46) pour convertir les données de forme d'onde d'entrée numériques en un signal d'attaque analogique ; et
une unité de conversion de courant (45) pour convertir le signal d'attaque en le courant d'attaque (id), dans lequel
l'unité de conversion N/A (46) convertit séquentiellement une pluralité de données de forme d'onde de sections continues obtenues en divisant la forme d'onde temporelle des données de forme d'onde d'entrée (Da) en le signal d'attaque tout en fournissant une différence de temps.

3. Appareil de traitement au laser selon la revendication 1 ou 2, dans lequel la largeur de temps de chacune des une ou une pluralité de pulsations lumineuses dans chaque groupe de pulsations lumineuses est de 1 microseconde ou moins.

4. Appareil de traitement au laser selon l'une quelconque des revendications 1 à 3, dans lequel l'intervalle de temps entre les deux groupes de pulsations lumineuses ou plus est de 200 microsecondes ou moins.

5. Appareil de traitement au laser selon l'une quelconque des revendications 1 à 4, dans lequel l'unité de sortie de forme d'onde (6) change la forme d'onde temporelle d'au moins un groupe de pulsations lumineuses parmi les deux groupes de pulsations lumineuses ou plus pendant le traitement de l'objet à traiter (B).

6. Appareil de traitement au laser selon l'une quelconque des revendications 1 à 5, dans lequel une largeur de pulsation des une ou une pluralité de pulsations lumineuses dans un groupe de pulsations lumineuses parmi les au moins deux groupes de pulsations lumineuses est égale à 10 fois, ou plus, une largeur de pulsation des une ou une pluralité de pulsations lumineuses dans un autre groupe de pulsations lumineuses.

7. Procédé de traitement au laser comprenant :
une étape d'alimentation en courant pour générer un courant d'attaque ayant une forme d'onde temporelle conformément à des données de forme d'onde d'entrée et appliquer le courant d'attaque à un élément laser à semi-conducteur (2) ; et
une étape d'irradiation lumineuse pour irradier un objet à traiter (B) avec une lumière laser délivrée en sortie par l'élément laser à semi-conducteur (2), dans lequel lors de l'étape d'irradiation lumineuse, l'élément laser à semi-conducteur (2) délivre en sortie la lumière laser dans laquelle deux groupes de pulsations lumineuses ou plus comprenant chacun une ou une pluralité de pulsations lumineuses sont fournis avec un intervalle de temps entre eux,
les formes d'onde temporelles d'au moins deux groupes de pulsations lumineuses parmi les deux groupes de pulsations lumineuses ou plus sont différentes les unes des autres,
la forme d'onde temporelle comporte au moins l'un parmi une forme d'onde temporelle de chacune des une ou une pluralité de pulsations lumineuses, une largeur de temps de chacune des une ou une pluralité de pulsations lumineuses, et un intervalle de temps de la pluralité de pulsations lumineuses, et **caractérisé en ce que** lors de l'étape d'irradiation lumineuse, l'objet à traiter (B) est irradié avec la lumière laser via un modulateur spatial de lumière (7), et **en ce que**
un hologramme pour irradier une première position d'irradiation avec le faisceau laser correspondant à un premier groupe de pulsations lumineuses compris dans les deux groupes de pulsations lumineuses ou plus et un hologramme pour irradier une seconde position d'irradiation différente de la première position d'irradiation avec la lumière laser correspondant à un second groupe de pulsations lumineuses sont présentés séquentiellement sur le modulateur spatial de lumière (7).

8. Procédé de traitement au laser selon la revendication 7, dans lequel l'étape d'alimentation en courant comporte :
une étape de conversion N/A pour convertir des données de forme d'onde d'entrée numériques en un signal d'attaque analogique ; et
une étape de conversion de courant pour convertir le signal d'attaque en le courant d'attaque (id), dans lequel, lors de l'étape de conversion N/A, une pluralité de données de forme d'onde de sections continues obtenues en divisant la forme d'onde temporelle des données de forme d'onde d'entrée (Da) sont séquentiellement converties en le signal d'attaque tout en fournissant une différence de temps.

9. Procédé de traitement au laser selon la revendication 7 ou 8, dans lequel la largeur de temps de chacune des une ou une pluralité de pulsations lumineuses dans chaque groupe de pulsations lumineuses est de 1 microseconde ou moins.

10. Procédé de traitement au laser selon l'une quelconque des revendications 7 à 9, dans lequel l'intervalle de temps entre les deux groupes de pulsations lumineuses ou plus est de 200 microsecondes ou moins.

11. Procédé de traitement au laser selon l'une quelconque des revendications 7 à 10, dans lequel la forme d'onde temporelle d'au moins un groupe de pulsations lumineuses parmi les deux groupes de pulsations lumineuses ou plus est modifiée pendant le traitement de l'objet à traiter (B).

12. Procédé de traitement au laser selon l'une quelconque des revendications 7 à 11, dans lequel une largeur de pulsation des une ou une pluralité de pulsations lumineuses dans un groupe de pulsations lumineuses parmi les au moins deux groupes de pulsations lumineuses est égale à 10 fois, ou plus, une largeur de pulsation des une ou une pluralité de pulsations lumineuses dans un autre groupe de pulsations lumineuses.
